# EUROPEAN PATENT SPECIFICATION

(11) **EP 4 398 037 B1**
(45) Date of publication and mention of the grant of the patent: **21.01.2026**
(21) Application number: 23219331.8
(22) Date of filing: 21.12.2023
(51) Int. Cl.: G03F 7/09, C07F 7/22, H01L 21/027, H01L 21/033

(54) **COMPOUND FOR FORMING METAL-CONTAINING FILM, COMPOSITION FOR FORMING METAL-CONTAINING FILM, AND PATTERNING PROCESS**
VERBINDUNG ZUR BILDUNG EINES METALLHALTIGEN FILMS, ZUSAMMENSETZUNG ZUR BILDUNG EINES METALLHALTIGEN FILMS UND STRUKTURIERUNGSVERFAHREN
COMPOSÉ POUR FORMER UN FILM CONTENANT UN MÉTAL, COMPOSITION POUR FORMER UN FILM CONTENANT UN MÉTAL, ET PROCÉDÉ DE FORMATION DE MOTIFS

(30) Priority: 06.01.2023 JP 2023000802
(43) Date of publication of application: 10.07.2024
(73) Proprietor: SHIN-ETSU CHEMICAL CO., LTD., Tokyo 100-0005 (JP)
(72) Inventor: Iwamori, Shohei, Niigata (JP); Kobayashi, Naoki, Niigata (JP); Kori, Daisuke, Niigata (JP)
(74) Representative: Sonnenhauser, Thomas Martin

(56) References cited:
- JP-A- 2022 521 531
- KR-A- 20220 144 787
- US-A- 3 053 870
- US-A1- 2015 064 904
- US-A1- 2019 187 560
- US-A1- 2021 333 708

## Description

### TECHNICAL FIELD

The present invention relates to: a compound for forming a metal-containing film; a composition for forming a metal-containing film; and a patterning process using the composition.

### BACKGROUND ART

As LSIs advance toward higher integration and higher processing speed, miniaturization of pattern rule is progressing rapidly. As a cutting-edge technology for miniaturization, ArF immersion lithography has been adopted for mass-producing 45-nm node devices and smaller. In addition to ArF immersion exposure, double exposure (double patterning) processes have been put to practical use in generations of 28-nm node devices and smaller, so that the formation of narrow-pitch patterns that exceed the optical limit has also become possible.

Furthermore, in the production of 20-nm node and smaller devices, studies have been carried out on multiple exposure (multi-patterning) processes for forming a pattern with a narrower pitch by repeating exposure and etching three or more times. However, multiple exposure processes have an increased number of steps, and are faced with the situation that costs rise considerably due to degradation in productivity caused by longer time spent in manufacturing and more frequent generation of defects.

In recent years, vacuum ultraviolet ray (EUV) lithography with a wavelength of 13.5 nm is attracting attention as an effective technology to replace a combination of ArF immersion lithography and multiple exposure process. By using this technology, it has become possible to form a fine pattern with a half pitch of 25 nm or less in one exposure.

Meanwhile, in EUV lithography, resist materials are strongly required to have higher sensitivity to compensate for insufficient output of a light source. However, increase in shot noise accompanying higher sensitization leads to increase in edge roughness (LER and LWR) of line patterns, and compatibility of higher sensitization and low edge roughness is given as an important problem in EUV lithography.

As an attempt to achieve higher sensitivity of a resist or to lower the influence of shot noise, it has been considered in recent years to use a metal material in a resist material. A compound that contains a metallic element such as barium, titanium, hafnium, zirconium, or tin has a higher absorbance of EUV light compared to an organic material that does not contain metal, and improvement of photosensitivity of resists and suppression of the influence of shot noise can be expected. Furthermore, a metal-containing resist pattern is expected to achieve a high-selectivity etching process by combining with an underlayer film made from a non-metal material.

For example, resist materials with added metal salt or organometallic complex disclosed in Patent Documents 1 and 2 or non-chemically amplified resist materials that use nanoparticles of metal oxide disclosed in Patent Documents 3 and 4 are considered.

In particular, molecules containing tin are excellent in the absorption of an electron beam and an extreme ultraviolet ray, and are actively researched. In the case of an organotin polymer, which is one such molecule, alkyl ligand is dissociated by light absorption or secondary electrons produced thereby and crosslinked with adjacent chains through an oxo bond, and thus enables the negative tone patterning which may not be removed by an organic developing solution. This organic tin polymer can improve sensitivity while maintaining a resolution and line edge roughness, but has not yet reached the standards for commercial availability (Patent Document 5). In addition, many problems still remain, such as insufficient storage stability regarding change in resist sensitivity.

To solve the problems, there is also consideration of development of the use of a material containing a metal element, such as titanium, hafnium, zirconium, and tin, for a resist underlayer film. There is no need for the improvement for performance, such as the enhancement of exposure sensitivity and the suppression of change in sensitivity in storage environment, which are issues in resist materials containing metal. In addition, it may be possible to provide a resist underlayer film excellent in dry etching resistance when the metal element is contained. Patent Document 6 reports that a material containing a Ti compound exhibits excellent dry etching resistance to CHF₃/CF₄-based gas and CO₂/N₂-based gas.

On the other hand, filling property is a problem when using a metal compound for a resist underlayer film. Although there is no mention of filling property in Patent Document 6, a metal compound generally has large thermal shrinkage during baking and induces remarkable degradation of filling after baking at a high temperature. Therefore, there is a concern that such a compound is insufficient as a resist underlayer film material for which high planarizing and filling properties and heat resistance are required. Patent Document 7 reports that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases). Patent Document 8 provides a resist underlayer film material excellent in filling property after baking at 400°C by mixing the metal compound reported in Patent Document 7 and an organic polymer having a particular structure. However, since the material is a mixed composition of a metal compound which is inorganic and a polymer which is organic, there are concerns for film formation defects, degradation of storage stability, degradation of dry etching resistance, etc. caused by compatibility failure.

### CITATION LIST

### PATENT LITERATURE

Patent Document 1: JP5708521B2
Patent Document 2: JP5708522B2
Patent Document 3: US9310684B2
Patent Document 4: US2017/0102612A1
Patent Document 5: JP2021-162865A
Patent Document 6: JP6189758B2
Patent Document 7: JP7050137B2
Patent Document 8: JP2022-521531A

### SUMMARY OF INVENTION

### TECHNICAL PROBLEM

The present invention has been made in view of the above-described circumstances. An object of the present invention is to provide: a compound for forming a metal-containing film having better dry etching resistance than conventional resist underlayer film materials and also having high filling and planarizing properties; a composition for forming a metal-containing film containing the compound; and a patterning process in which the composition is used.

### SOLUTION TO PROBLEM

To achieve the object, the present invention provides a compound for forming a metal-containing film to be contained in a composition for forming a metal-containing film, wherein the compound is represented by the following general formula (M),

Tₙ-Sn-Qₘ (M)

wherein T represents a group represented by the following general formula (1) or a group represented by the following general formula (1'), at least one T representing a group represented by the following general formula (1) and T optionally being one kind or a combination of two or more kinds; Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups; and "m" and "n" represent any integer, provided that "m" and "n" satisfy the relationship m+n = 4, m ≥ 1, and n ≥ 2, 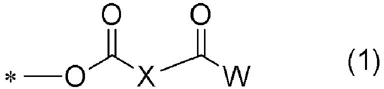 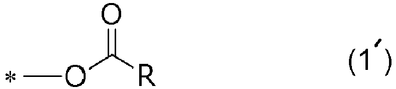 wherein X represents a divalent organic group having 1 to 31 carbon atoms, W represents a group represented by one of the following general formulae (W-1) to (W-4), and "*" represents an attachment point to a Sn atom in the general formula (1); and R represents any substituent and "*" represents an attachment point to a Sn atom in the general formula (1'), 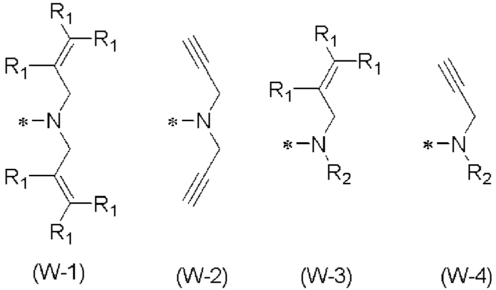 wherein R₁'s each represent a hydrogen atom or a methyl group and are identical to or different from each other in the general formulae (W-1) and (W-3); and R₂ represents a hydrogen atom, a substituted or unsubstituted saturated monovalent organic group having 1 to 20 carbon atoms or a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms in (W-3) and (W-4), and "*" represents an attachment point to a carbonyl group.

Such a tetravalent compound for forming a metal-containing film is a tin-containing compound having excellent solvent solubility. In addition, the general formula (1) includes a structure represented by (W-1) to (W-4) and has a high density of crosslinking groups, so that the compound has excellent thermosetting property. Therefore, when the compound is contained in a composition for forming a metal-containing film, it is possible to provide a resist material that has excellent dry etching resistance and undergoes little volume shrinkage during baking, and unlike tin-containing compounds for forming a resist upper layer film such as those reported in Patent Document 5, has excellent film-formability and planarizing and filling properties even after high-temperature baking.

The X in the general formula (1) preferably represents an unsaturated hydrocarbon group having 2 to 20 carbon atoms.

When the X in the general formula (1) represents an unsaturated hydrocarbon group having 2 to 20 carbon atoms, the thermosetting property of the compound for forming a metal-containing film can be improved further.

Furthermore, the X in the general formula (1) preferably represents a group represented by one of the following general formulae (2), 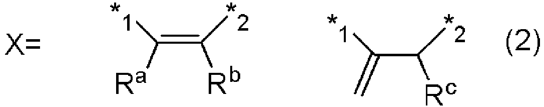 wherein R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*₁" and "*₂" each represent an attachment point to a carbonyl group, "*₁" and "*₂" optionally being reversed.

A compound for forming a metal-containing film having such a structure can achieve high levels of both thermal flowability and thermosetting property. When this compound is contained in a composition for forming a metal-containing film, it is possible to provide a resist material that exhibits better planarizing and filling properties.

The compound for forming a metal-containing film preferably satisfies 1.00 ≤ Mw/Mn ≤ 1.50, where Mw is a weight-average molecular weight and Mn is a number-average molecular weight measured by gel permeation chromatography in terms of polystyrene.

A compound for forming a metal-containing film having dispersity of such a range has even better thermal flowability, so that when the compound is contained in a composition for forming a metal-containing film, not only is it possible to fill favorably a fine structure formed on a substrate, it is also possible to form a resist film so that the entire substrate is flat.

In addition, the present invention provides a composition for forming a metal-containing film used in manufacturing a semiconductor, the composition comprising: (A) the above-described compound for forming a metal-containing film; and (B) an organic solvent.

Such a composition for forming a metal-containing film contains an organotin compound excellent in heat resistance and thermal flowability, and therefore, can provide a resist material having better dry etching resistance than conventional resist underlayer film materials and also having high filling and planarizing properties.

The composition can further comprise one or more of (C) a crosslinking agent, (E) a surfactant, (F) a flowability accelerator, and (G) an acid generator.

A composition for forming a metal-containing film containing such additives can achieve a composition for forming a metal-containing film having better coating property, dry etching resistance, and filling and planarizing properties.

Furthermore the organic solvent (B) preferably contains, as (B1) a high-boiling-point solvent, one or more kinds of organic solvent having a boiling point of 180°C or higher.

By the composition for forming a metal-containing film being provided with thermal flowability by containing a high-boiling-point solvent, the composition for forming a metal-containing film can have both higher filling and planarizing properties.

In addition, the present invention provides a patterning process for forming a pattern in a substrate to be processed, comprising the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The patterning process by way of the two-layer resist process makes it possible to form fine patterns on the body to be processed (substrate to be processed).

The present invention also provides a patterning process for forming a pattern in a substrate to be processed, comprising the steps of:
(II-1) applying the above-described composition for forming a metal-containing film onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

The patterning process by way of the three-layer resist process makes it possible to form fine patterns on the body to be processed with a high degree of accuracy.

The present invention also provides a patterning process for forming a pattern in a substrate to be processed, comprising the steps of:
(III-1) applying the above-described composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

The patterning process by way of the four-layer resist process makes it possible to form fine patterns on the body to be processed with a high degree of accuracy.

In this case, the inorganic hard mask middle layer film is preferably formed by a CVD method or an ALD method.

When the inorganic hard mask middle layer film is formed by a CVD method or an ALD method, a fine pattern can be formed on a body to be processed with higher accuracy.

The present invention also provides a patterning process for forming a pattern in a substrate to be processed, comprising the steps of:
(IV-1) forming a resist underlayer film on a substrate to be processed;
(IV-2) applying the above-described composition for forming a metal-containing film onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the organic adhesive film and the metal-containing film or the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

The patterning process by way of the multilayer resist process makes it possible to form fine patterns on the body to be processed with a high degree of accuracy.

The present invention also provides a tone-reversal patterning process for forming a pattern in a substrate to be processed, comprising the steps of:
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

The patterning process by way of the reverse process makes it possible to form fine patterns on the body to be processed with a higher degree of accuracy.

### ADVANTAGEOUS EFFECTS OF INVENTION

As described above, the inventive compound for forming a metal-containing film is a tetravalent compound for forming a metal-containing film shown by the general formula (M), and therefore, is a tin-containing compound excellent in solvent solubility. Furthermore, in the general formula (1), a structure represented by (W-1) to (W-4) is included, and therefore, the compound has a high crosslinking group density, and is also excellent in thermosetting property. Thus, when the compound is contained in a composition for forming a metal-containing film, it is possible to provide a resist material that undergoes little volume shrinkage during baking, and is excellent in film-formability and planarizing and filling properties even after baking at a high temperature.

In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. In addition, the inventive compound has better dry etching resistance than conventional coating-type resist underlayer film materials, and therefore, a fine pattern can be formed on a body to be processed with even higher precision compared with a resist underlayer film.

A composition for forming a metal-containing film containing the compound of the present invention for forming a metal-containing film contains tin atoms, which have high light absorbance, and therefore, has a sensitizing effect caused by secondary electrons generated from the tin atoms during exposure. Furthermore, tin atoms have a great atomic weight, and therefore, have a high effect of suppressing the diffusion of acid from a resist upper layer film to a resist underlayer film, and have a characteristic that higher sensitivity can be achieved while sustaining the LWR performance that the resist upper layer film originally has.

### BRIEF DESCRIPTION OF DRAWINGS

FIG. 1 is an explanatory view of an example (three-layer resist process) of the patterning process of the present invention.
FIG. 2 is an explanatory view of an example (forming reverse SOC pattern of a three-layer resist process) of the tone-reversal patterning process of the present invention.
FIG. 3 is an explanatory view of a method for evaluating the filling property.
FIG. 4 is an explanatory view of a method for evaluating the planarizing property.

### DESCRIPTION OF EMBODIMENTS

As stated above, there have been demands for the development of: a composition for forming a metal-containing film, excellent in filling property and planarization property, used for forming a resist underlayer film that makes it possible to transfer a resist pattern to a substrate to be processed with higher precision in a fine patterning process according to a multilayer resist method; and a compound for forming a metal-containing film useful for the composition.

The present inventors have focused on organotin compounds, which are expected to play an active role in the EUV-exposure generation, and studied earnestly. As stated above, tin atoms, which greatly absorb light, have a sensitizing effect due to secondary electrons generated from the atoms during exposure, and have a characteristic that higher sensitivity can be achieved while maintaining the LWR performance that a resist upper layer film originally has. On the other hand, organotin compounds, which are considered as resist underlayer films, have poor heat resistance, and undergo rapid volume shrinkage during baking. Therefore, it is difficult to fill and planarize the steps of a substrate to be processed after high-temperature baking. The present inventors have considered that a compound having an organic group excellent in heat resistance can reduce rapid volume shrinkage at the time of baking and also improve thermal flowability, so that steps of a substrate to be processed can be filled without voids being generated even after baking at a high temperature. Furthermore, the present inventors have conjectured that when the compound has a structure including a crosslinking group at an end, thermosetting property during baking becomes excellent, and therefore, the compound for forming a metal-containing film would have better heat resistance.

The present inventors have studied earnestly further, and found out that a compound for forming a metal-containing film including at least one organic group represented by the general formula (1) gives a composition for forming a metal-containing film that can reduce sudden volume shrinkage during baking since the composition has excellent thermosetting property, can realize high filling and planarizing properties since the composition also has good thermal flowability, can contribute to the improvement of sensitivity while maintaining the LWR of a resist upper layer film since the composition contains tin atoms, and has excellent dry etching resistance since alkyl ligand is dissociated after high-temperature baking and forms SnO₂ by crosslinking with adjacent chains through an oxo bond. Thus, the present invention has been completed.

That is, the present invention is a compound for forming a metal-containing film to be contained in a composition for forming a metal-containing film, wherein the compound is represented by the following general formula (M),

Tₙ-Sn-Qₘ (M)

wherein T represents a group represented by the following general formula (1) or a group represented by the following general formula (1'), at least one T representing a group represented by the following general formula (1) and T optionally being one kind or a combination of two or more kinds; Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups; and "m" and "n" represent any integer, provided that "m" and "n" satisfy the relationship m+n = 4, m ≥ 1, and n ≥ 2, 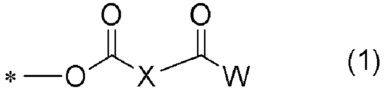 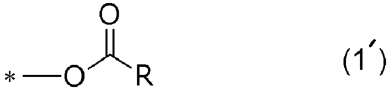 wherein X represents a divalent organic group having 1 to 31 carbon atoms, W represents a group represented by one of the following general formulae (W-1) to (W-4), and "*" represents an attachment point to a Sn atom in the general formula (1); and R represents any substituent and "*" represents an attachment point to a Sn atom in the general formula (1'), 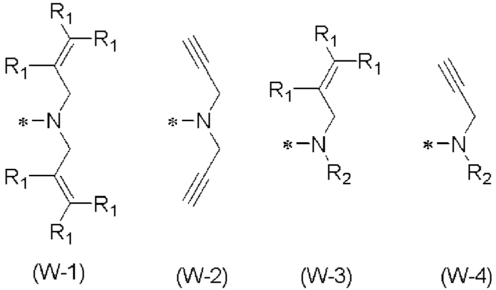 wherein R₁'s each represent a hydrogen atom or a methyl group and are identical to or different from each other in the general formulae (W-1) and (W-3); and R₂ represents a hydrogen atom, a substituted or unsubstituted saturated monovalent organic group having 1 to 20 carbon atoms or a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms in (W-3) and (W-4), and "*" represents an attachment point to a carbonyl group.

Hereinafter, the present invention will be described in detail, but the present invention is limited to the scope of the claims, only.

### <Compound for Forming Metal-Containing Film>

The inventive compound for forming a metal-containing film is represented by the following general formula (M).

Tₙ-Sn-Qₘ (M)

In the general formula (M), T represents a group represented by the following general formula (1) or a group represented by the following general formula (1'), at least one T representing a group represented by the following general formula (1) and T optionally being one kind or a combination of two or more kinds; Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups; and "m" and "n" represent any integer, provided that "m" and "n" satisfy the relationship m+n = 4, m ≥ 1, and n ≥ 2.

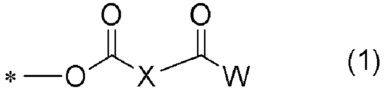

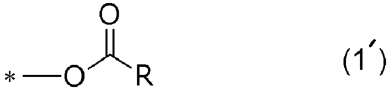

X represents a divalent organic group having 1 to 31 carbon atoms, W represents a group represented by one of the following general formulae (W-1) to (W-4), and "*" represents an attachment point to a Sn atom in the general formula (1); and R represents any substituent and "*" represents an attachment point to a Sn atom in the general formula (1').

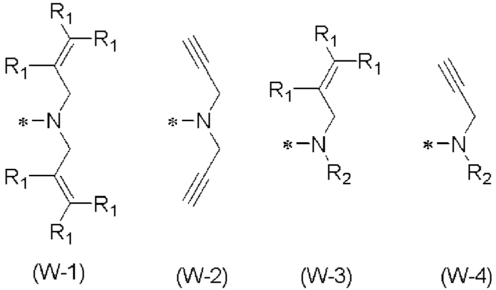

R₁'s each represent a hydrogen atom or a methyl group and are identical to or different from each other in the general formulae (W-1) and (W-3); and R₂ represents a hydrogen atom, a substituted or unsubstituted saturated monovalent organic group having 1 to 20 carbon atoms or a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms in (W-3) and (W-4), and "*" represents an attachment point to a carbonyl group.

In the general formula (M), T represents a group represented by the general formula (1) or a group represented by the general formula (1'), at least one T representing a group represented by the general formula (1) and T optionally being one kind or a combination of two or more kinds. Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups. Q is more preferably an unsubstituted alkyl group having 1 to 20 carbon atoms, and from the availability of raw materials, Q is particularly preferably an n-butyl group.

In the general formula (M), "n" and "m" preferably satisfy n=3 and m=1 or n=2 and m=2 from the viewpoints of the safety and thermosetting property of the compound, and in particular, more preferably satisfy n=2 and m=2 from the ease of obtaining raw materials.

In the general formula (1), X represents a divalent organic group having 1 to 31 carbon atoms, and specific examples include substituted or unsubstituted saturated divalent hydrocarbon groups having 1 to 20 carbon atoms or substituted or unsubstituted unsaturated divalent hydrocarbon groups having 2 to 20 carbon atoms, substituted or unsubstituted aryl groups having 6 to 30 carbon atoms, and substituted or unsubstituted arylalkyl groups having 7 to 31 carbon atoms. W represents a group represented by one of the general formulae (W-1) to (W-4), and in (W-1) and (W-3), R₁ is preferably a methyl group from the viewpoint of thermal flowability, and is preferably a hydrogen atom from the viewpoint of curability. Meanwhile, the R₂ in (W-3) and (W-4) is preferably a structure given above other than a hydrogen atom, from the viewpoint of thermal flowability.

Examples of preferable structures for the X in the general formula (1) include the following structures, but are not limited thereto.

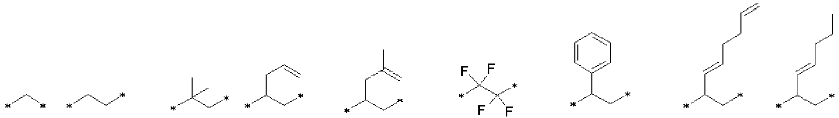

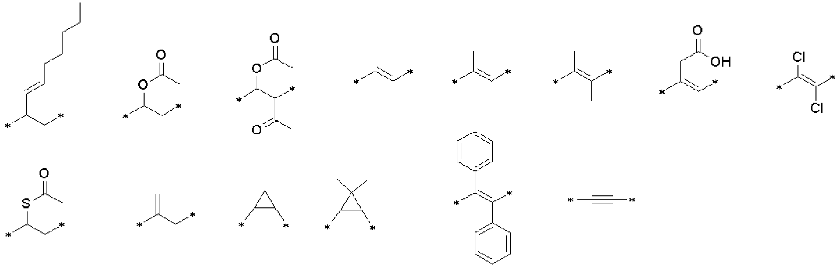

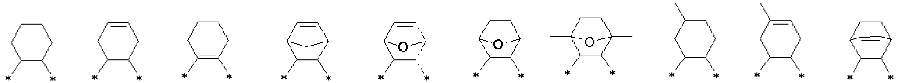

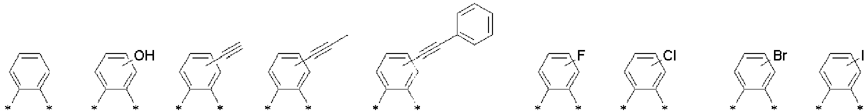

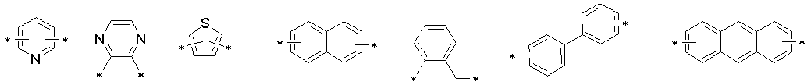

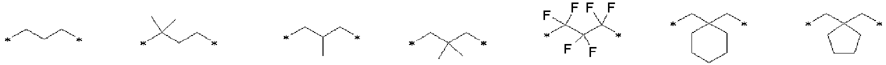

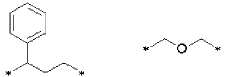

"*" represents an attachment point to a carbon atom of a carbonyl group.

In the general formulae (W-1) to (W-4), examples of preferable structures for R₂ include the following structures, but are not limited thereto.

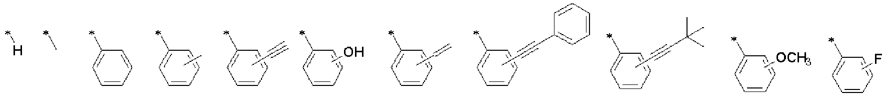

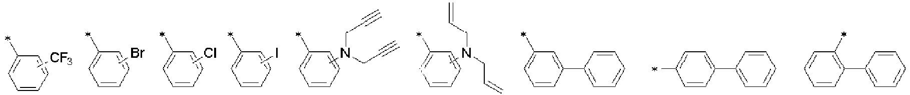

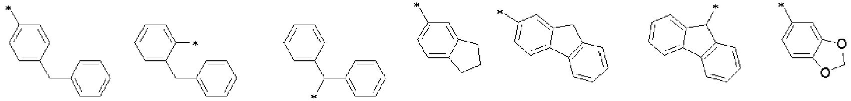

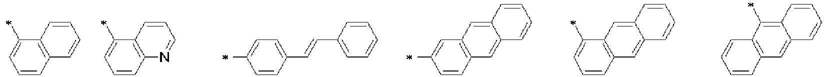

"*" represents an attachment point to the nitrogen atom.

A compound for forming a metal-containing film having such a structure contains an organic group represented by the general formula (1), and therefore, is excellent in solvent solubility and heat resistance. Furthermore, since the compound includes one of the structures represented by the general formulae (W-1) to (W-4) on an end, the density of crosslinking groups is high, and sudden volume shrinkage during baking can be reduced. Since the compound also has good thermal flowability, a resist material having excellent filling and planarizing properties can be provided.

A compound having a structure represented by the general formula (M) can be synthesized by condensation between a tin oxide, a tin chloride, or the like and a carboxylic acid including X and W as in the following formula. In this event, it is also possible to use together a plurality of carboxylic acid components having different X and W. In the following formula, "n" and "m" are as described in the description of the general formula (M).

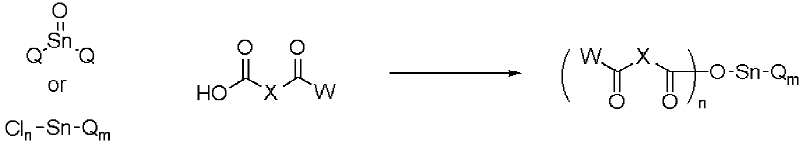

Furthermore, as shown in the following formulae, it is also possible to use a carboxylic acid different from the carboxylic acid including X and W in combination. For example, in accordance with required performance, such as film-formability and solvent solubility, a carboxylic acid component (an organic group represented by the general formula (1')) having a terminal group or functional group different from that of the organic group represented by the general formula (1) and combine the groups at any proportion. In the following formula, R represents any substituent, "n" and "m" are as described in the description of the general formula (M), and "m₁" and "m₂" each represent any integer and satisfy m₁ ≥ 1, m₁+m₂ ≥ 2, and m₁+m₂+m = 4.

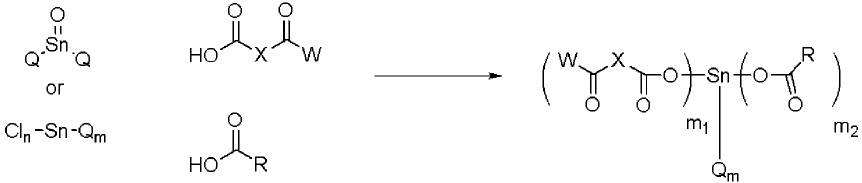

As specific examples of a carboxylic acid to be mixed, a carboxylic acid shown below can be used. It is possible to select appropriately a carboxylic acid to be added depending on the purpose, for example, if it is desired to provide adhesiveness, a carboxylic acid containing a hydroxy group, etc. can be selected, and if it is desired to improve thermal flowability, a carboxylic acid containing a long chain alkyl or the like can be selected, etc. In addition, since crystallinity can be suppressed by mixing the carboxylic acids, solvent solubility and thermal flowability are also improved. Meanwhile, from the viewpoint of preventing the degradation of thermosetting property due to reduced crosslinking group density, the carboxylic acid including X and W is preferably charged at a proportion of 50 mol% or more, further preferably 70 mol% or more of all the carboxylic acids. 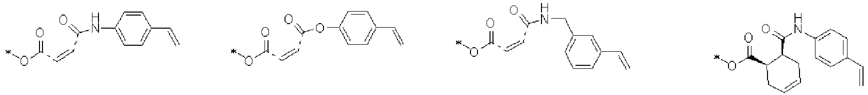 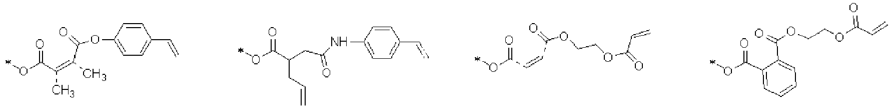 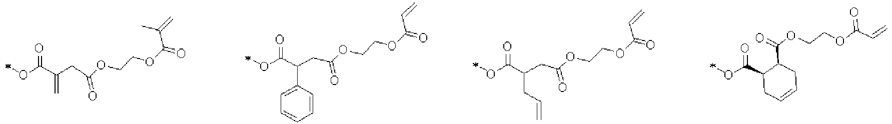 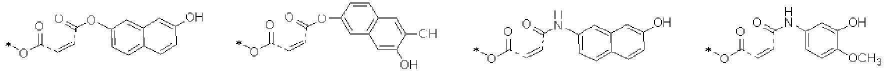 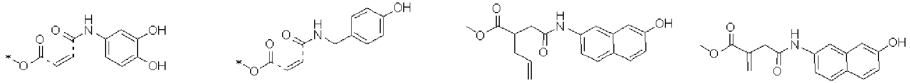 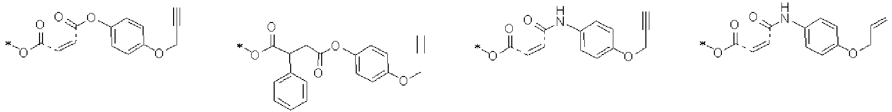 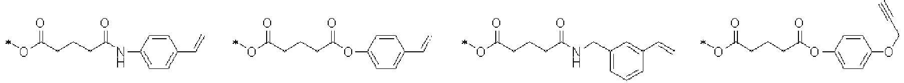 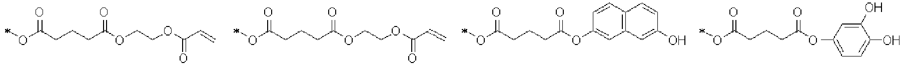 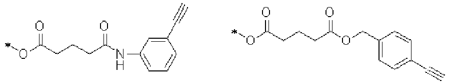 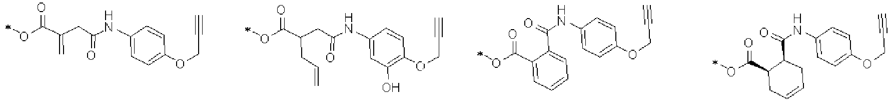 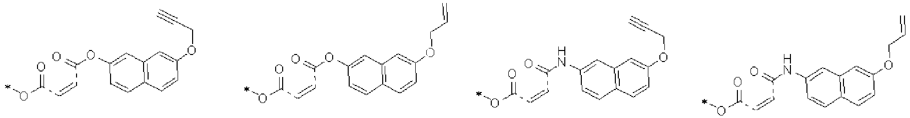 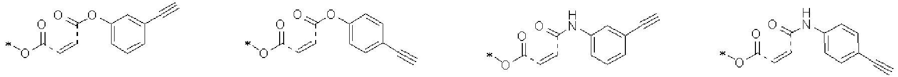 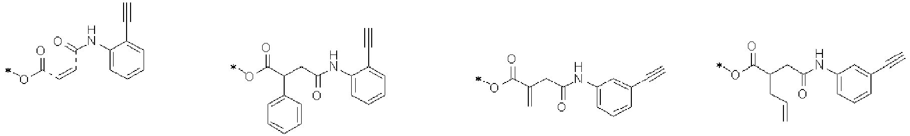 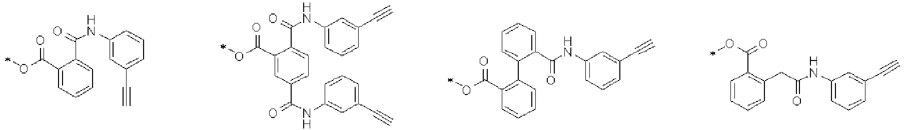 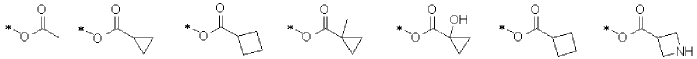 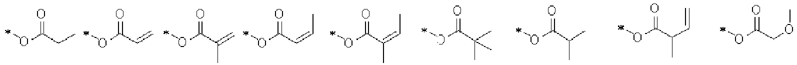 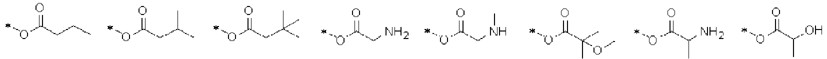 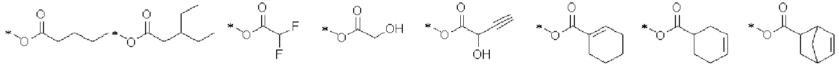 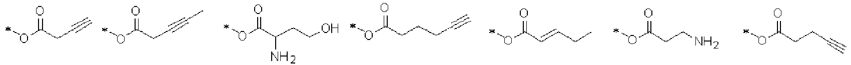 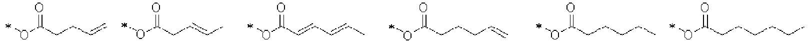 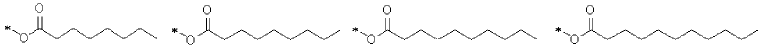 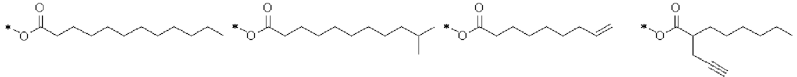 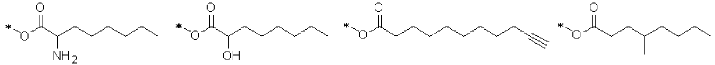 "*" represents an attachment point to the tin atom.

A metal-containing film formed by using the inventive compound for forming a metal-containing film generates radicals, while organic groups bonded to Sn atoms via C atoms are dissociated during baking. Radicals generated in this manner form -Sn-O-Sn- bonds and initiate a condensation polymerization reaction. Thus, curing of a metal-containing film progresses. Meanwhile, since organic groups are removed at the time of the reaction, great film shrinkage occurs during baking. However, the compound has at least one organic group represented by the general formula (1) including a crosslinking group having the structure represented by (W-1) to (W-4) on an end, and therefore, pyrolysis can be alleviated. Furthermore, since the compound is also excellent in thermal flowability, it is possible to provide a resist material having excellent filling property.

In the general formula (1), X preferably represents an unsaturated hydrocarbon group having 2 to 20 carbon atoms.

A compound for forming a metal-containing film having such a structure can improve thermosetting property further.

In the general formula (1), X is preferably a group represented by one of the following general formulae (2).

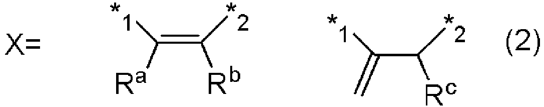

In the general formulae (2), R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*₁" and "*₂" each represent an attachment point to a carbonyl group, "*₁" and "*₂" optionally being reversed.

The synthesis of a compound that includes one of the general formulae (2) is performed by condensation between a tin oxide, a tin chloride, etc. and a carboxylic acid as in the following reaction formula, and the carboxylic acid to be used can be synthesized by ring-opening an acid anhydride. In the following formula, "n" and "m" are as described in the description of the general formula (M), and "n₁" and "n₂" each represent any integer and satisfy n₁+n₂ ≥ 2 and n₁+n₂+m = 4. In this event, when an asymmetric carboxylic anhydride is ring-opened, a mixture of two kinds is obtained, and therefore, the above-described bonding form is obtained. Crystallinity can be suppressed by the presence of such isomers, and improvement in solvent solubility and improvement in thermal flowability can be expected.

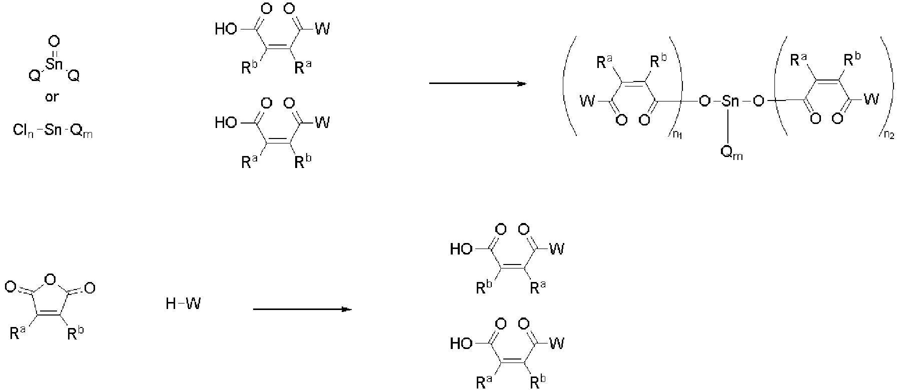

In the general formulae (2), R^{a} and R^{b} each represent a hydrogen atom or a monovalent organic group having 1 to 18 carbon atoms; R^{c} represents a hydrogen atom or a monovalent organic group having 1 to 17 carbon atoms; and R^{a} and R^{b} have a total of 0 to 18 carbon atoms, R^{a} and R^{b} optionally being bonded to each other to form a cyclic substituent. From the viewpoint of suppressing sublimation products, a hydrogen atom is particularly preferable.

A compound for forming a metal-containing film having such a structure can achieve both thermal flowability and thermosetting property, and when the compound is contained in a composition for forming a metal-containing film, it is possible to provide a resist material that maintains planarizing and filling properties.

The compound for forming a metal-containing film preferably has a ratio Mw/Mn (that is, dispersity) within the range of 1.00 ≤ Mw/Mn ≤ 1.50, further preferably 1.00 ≤ Mw/Mn ≤ 1.40, where Mw is a weight-average molecular weight and Mn is a number-average molecular weight measured by gel permeation chromatography in terms of polystyrene. From the definition, Mw/Mn is 1.00 in the case of a monomolecular compound, but because of separation in GPC, the measured value exceeds 1.00 in some cases. Generally, it is extremely difficult to bring the Mw/Mn of a polymer having a repeating unit close to 1.00 unless a special polymerization method is used. Such a polymer has a distribution of Mw, and Mw/Mn exceeds 1. In the present invention, the range 1.00 ≤ Mw/Mn ≤ 1.50 is defined as an index to indicate monomerism in order to distinguish between monomolecular compounds and polymers.

A compound for forming a metal-containing film having dispersity within such a range has even better thermal flowability, so that when the compound is contained in a composition for forming a metal-containing film, not only is it possible to fill favorably fine structures formed on a substrate, it is also possible to form a resist film to planarize the entire substrate.

### <Composition for Forming Metal-Containing Film>

Furthermore, the present invention can provide a composition for forming a metal-containing film used in manufacturing a semiconductor, the composition containing: (A) the above-described compound for forming a metal-containing film; and (B) an organic solvent.

Such a composition for forming a metal-containing film contains an organotin compound having high levels of both thermal flowability and thermosetting property, and therefore, can provide a resist material that has better dry etching resistance than conventional resist underlayer film materials and also has high filling and planarizing properties. The inventive composition for forming a metal-containing film is particularly suitable as a resist underlayer film material.

In the following, the components contained in the inventive composition for forming a metal-containing film other than the compound (A) for forming a metal-containing film will be described.

### <(B) Organic Solvent>

The organic solvent (B) usable in the inventive composition for forming a metal-containing film is not particularly limited as long as the solvent can dissolve the compound (A) for forming a metal-containing film and, when contained, (C) a crosslinking agent, (E) a surfactant, (F) a flowability accelerator, (G) an acid generator, and other additives described below.

Specifically, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent (B) is preferably contained in an amount of 200 to 10,000 parts by mass, more preferably 250 to 5,000 parts by mass relative to 100 parts by mass of the compound (A) for forming a metal-containing film.

The composition contains at least one kind of the compound (A) for forming a metal-containing film and the organic solvent (B), and as necessary, the composition may contain additives such as a crosslinking agent (C), a surfactant (E), a flowability accelerator (F), and an acid generator (G).

In the following, the components contained in the inventive composition for forming a metal-containing film other than the compound (A) for forming a metal-containing film and the organic solvent (B) will be described.

### <(B1) High-Boiling-Point Solvent>

In the inventive composition for forming a metal-containing film, the organic solvent (B) may be a mixture of one or more kinds of organic solvent having a boiling point of lower than 180°C and one or more kinds of organic solvent having a boiling point of 180°C or higher ((B1) a high-boiling-point solvent). That is, the organic solvent (B) preferably contains one or more kinds of organic solvent having a boiling point of 180°C or higher as a high-boiling-point solvent (B1).

The high-boiling-point solvent (B1) is not particularly limited to hydrocarbons, alcohols, ketones, esters, ethers, or chlorine-based solvents as long as the solvent is capable of dissolving the components of the inventive composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B1) may be selected suitably from the solvents above, for example, depending on the temperature at which the inventive composition for forming a metal-containing film is heat-treated, etc. The boiling point of the high-boiling-point solvent (B1) is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a resist film excellent in filling and planarizing properties. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (B1) is used, the contained amount is preferably 1 to 30 parts by mass per 100 parts by mass of the organic solvent, having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

### [(C) Crosslinking Agent]

To increase the curability of the compound for forming a metal-containing film and further inhibit intermixing with the resist upper layer film, the inventive composition for forming a metal-containing film may also contain a crosslinking agent (C). The crosslinking agent is not particularly limited, and various known crosslinking agents can be widely used. Examples include melamine-based crosslinking agents, acrylate-based crosslinking agents, glycoluril-based crosslinking agents benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol or alkoxymethyl-based crosslinking agents). The crosslinking agent (C) is preferably contained in an amount of 5 to 50 parts by mass, more preferably 10 to 40 parts by mass relative to 100 parts by mass of the compound (A) for forming a metal-containing film.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1).

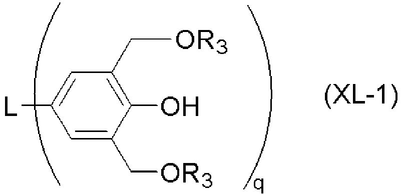

In the general formula (XL-1), L represents a single bond or a q-valent hydrocarbon group having 1 to 20 carbon atoms; R₃ represents a hydrogen atom or an alkyl group having 1 to 20 carbon atoms; and "q" represents an integer of 1 to 5.

L represents a single bond or a hydrocarbon group having a valency of "q" and having 1 to 20 carbon atoms. "q" represents an integer of 1 to 5, more preferably 2 or 3. Specific examples of L include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R₃ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, a hexamethoxymethylated derivative of triphenolmethane, triphenolethane, 1,1,1-tris(4-hydroxyphenyl)ethane, and tris(4-hydroxyphenyl)-1-ethyl-4-isopropylbenzene are preferable from the viewpoint of improving the curability and film thickness uniformity of the metal-containing film. R₃ is as defined above.

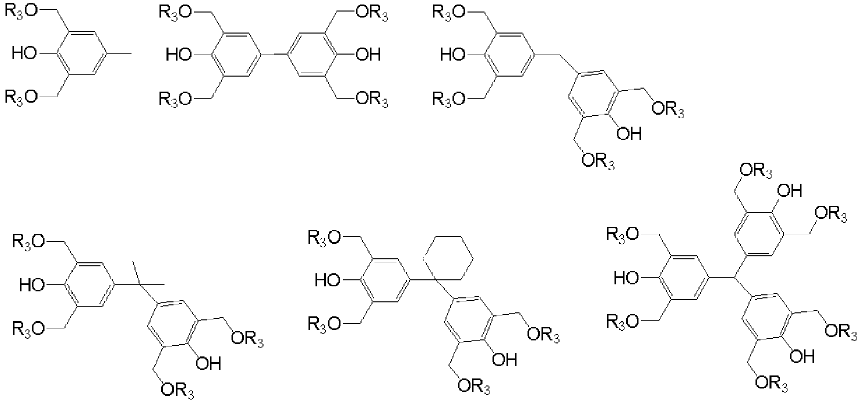

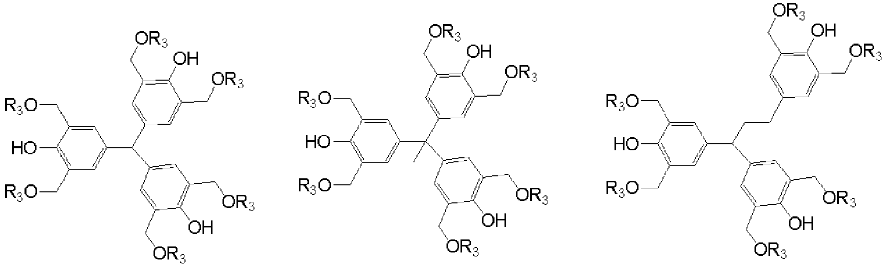

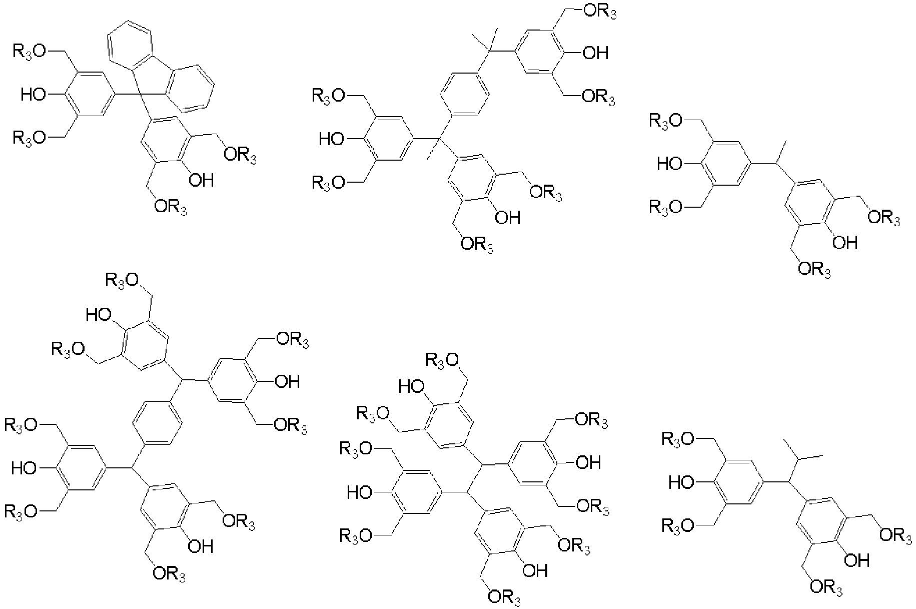

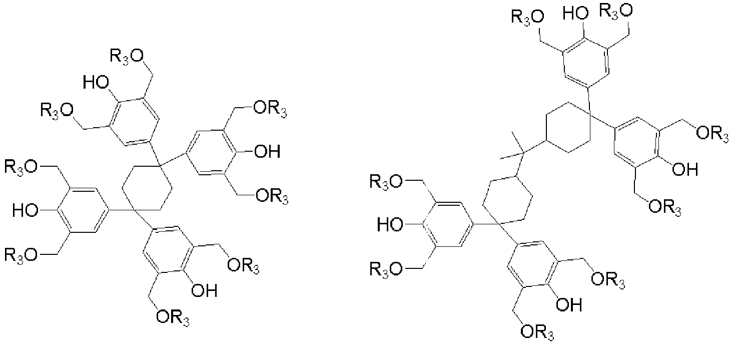

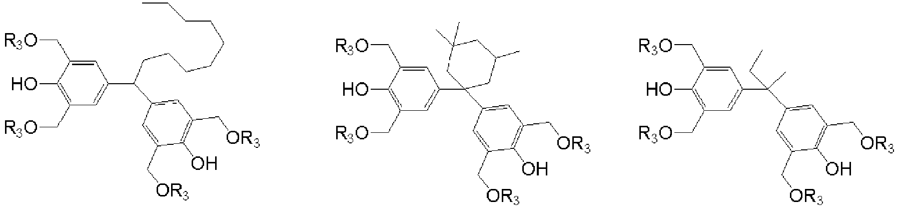

### <(E) Surfactant>

A surfactant (E) may be contained in the inventive composition for forming a metal-containing film in order to improve coating property in spin-coating. Examples of the surfactant include those disclosed in paragraphs [0142] to [0147] of JP2009-269953A. When the surfactant is contained, the contained amount is preferably 0.01 to 10 parts by mass, more preferably 0.05 to 5 parts by mass per 100 parts by mass of the compound (A) for forming a metal-containing film.

### <(F) Flowability Accelerator>

Another compound or polymer may be further blended in the inventive composition for forming a metal-containing film. The flowability accelerator (F) is mixed with the inventive compound for forming a metal-containing film and serves to improve the film-formability by spin-coating and the filling property for a stepped substrate. Furthermore, as the flowability accelerator (F), a material having a high density of carbon atoms and high etching resistance is preferable.

Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, and 7-methoxy-2-naphthol, dihydroxynaphthalene such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth) acrylate, and copolymers thereof. In addition, the composition may contain a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenolic group disclosed in JP2006-227391A, a bisphenol compound and a novolak resin thereof disclosed in JP2006-293298A, a novolak resin of an adamantane phenol compound disclosed in JP2006-285095A, a bisnaphthol compound and a novolak resin thereof disclosed in JP2010-122656A, a fluorene compound disclosed in JP2017-119671A, a fullerene resin compound disclosed in JP2008-158002A, and the like. The flowability accelerator is preferably contained in an amount of 0.001 to 100 parts by mass, more preferably 0.01 to 50 parts by mass based on 100 parts by mass of the inventive compound (A) for forming a metal-containing film.

In addition, in the inventive composition for forming a metal-containing film, it is preferable to use, as an additive for imparting filling and planarizing properties, for example, a liquid additive having a polyethylene glycol or polypropylene glycol structure, or a thermo-decomposable polymer having a weight reduction rate of 40% by mass or more at 30°C to 250°C and a weight-average molecular weight of 300 to 200,000. This thermo-decomposable polymer preferably contains a repeating unit having an acetal structure represented by the following general formula (DP1) or (DP1a).

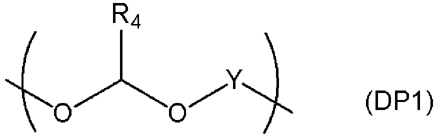

In the general formula (DP1), R₄ represents a hydrogen atom or a substituted or unsubstituted, saturated or unsaturated monovalent organic group having 1 to 30 carbon atoms. Y represents a saturated or unsaturated divalent organic group having 2 to 30 carbon atoms.

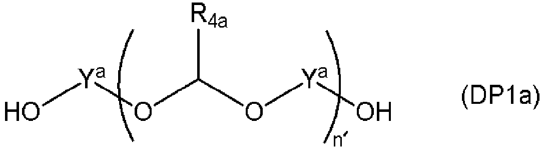

In the general formula (DP1a), R₄ₐ represents an alkyl group having 1 to 4 carbon atoms. Y^{a} represents a saturated or unsaturated divalent hydrocarbon group having 4 to 10 carbon atoms and optionally having an ether bond. "n'" represents an average repeating unit number of 3 to 500.

### <(G) Acid Generator>

An acid generator may be contained in the inventive composition for forming a metal-containing film in order to promote the curing reaction of the compound (A) for forming a metal-containing film further. The acid generator can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When an acid generator is contained, the contained amount is preferably 0.05 to 50 parts by mass, more preferably 0.1 to 10 parts by mass relative to 100 parts by mass of the compound (A) for forming a metal-containing film.

### <Method for Forming Resist Underlayer Film and Filling Film>

The present invention provides a method of forming, by using the above-described composition for forming a metal-containing film, a resist underlayer film of a multilayer resist film used in lithography or a filling film that serves as a planarizing film for the manufacture of semiconductor.

In the method for forming a resist underlayer film, by using the inventive composition for forming a metal-containing film, the substrate to be processed is coated with the above-described composition for forming a metal-containing film by a spin-coating method or the like. Using the spin-coating method or the like ensures a desirable filling property. After spin-coating, baking (heating) is performed so as to evaporate the solvent and promote a crosslinking reaction to prevent mixing of the resist underlayer film with the resist upper layer film or the resist middle layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

In the method for forming a resist underlayer film where the inventive composition for forming a metal-containing film is used, a substrate to be processed may also be coated with the inventive composition for forming a metal-containing film by spin-coating or the like in the same manner as described above, and then the composition for forming a metal-containing film may be baked and cured under an atmosphere having an oxygen concentration of 0.1 volume % or more and 21 volume % or less to form a metal-containing film as a resist underlayer film.

By baking the inventive composition for forming a metal-containing film in such an oxygen atmosphere, a sufficiently cured film can be obtained. The atmosphere during baking may be air; however, to prevent oxidation of the metal-containing film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation of the metal-containing film during the baking, the absorption does not increase and the etching resistance does not decrease, which is preferable.

The method for forming a filling film may be similar to the method for forming a resist underlayer film.

### <Patterning Process Using Composition for Forming Metal-Containing Film>

The present invention provides, as a patterning process according to a two-layer resist process using the above-described composition for forming a metal-containing film, a patterning process for forming a pattern in a substrate to be processed, including the steps of:
(I-1) applying the above-described composition for forming a metal-containing film onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

The resist upper layer film in the two-layer resist process described above exhibits etching resistance with respect to chlorine-based gas. Therefore, the dry etching of the metal-containing film that is performed while using the resist upper layer film as a mask in the two-layer resist process is preferably performed using an etching gas mainly containing a chlorine-based gas.

The present invention provides, as a patterning process according to a three-layer resist process using the above-described composition for forming a metal-containing film, a patterning process for forming a pattern in a substrate to be processed, including the steps of:
(II-1) applying the above-described composition for forming a metal-containing film onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

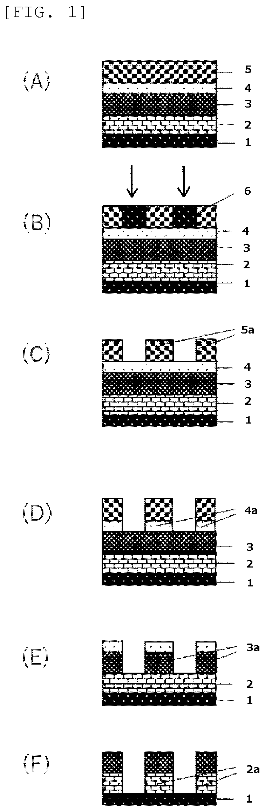

With reference to FIG. 1, a patterning process according to a three-layer resist process will be described. The present invention provides, as a patterning process according to a three-layer resist process using such a composition for forming a metal-containing film, the patterning process including:
forming a metal-containing film 3 on a layer 2 to be processed on a substrate 1 to be processed by using the composition for forming a metal-containing film, forming a silicon-containing resist middle layer film 4 on the metal-containing film by using a silicon-containing resist middle layer film material, and forming a resist upper layer film 5 on the silicon-containing resist middle layer film by using a photoresist material as in FIG. 1(A);
subsequently subjecting an exposure portion 6 of the resist upper layer film to pattern exposure as in FIG. 1(B) and then development with a developer to form a resist upper layer film pattern 5a in the resist upper layer film as in FIG. 1(C);
transferring a silicon-containing resist middle layer film pattern 4a to the silicon-containing resist middle layer film by dry etching while using the resist upper layer film having the formed pattern as a mask as in FIG. 1(D);
transferring a metal-containing film pattern 3a to the metal-containing film by dry etching while using the silicon-containing resist middle layer film having the transferred pattern as a mask as in FIG. 1(E); and
processing the layer to be processed on the substrate to be processed while using the metal-containing film having the formed pattern as a mask to form a pattern 2a on the substrate 1 to be processed as in FIG. 1(F).

The silicon-containing resist middle layer film in the three-layer resist process exhibits etching resistance with respect to a chlorine-based gas and a hydrogen-based gas. Therefore, the dry etching of the metal-containing film that is performed while using the silicon-containing resist middle layer film as a mask in the three-layer resist process is preferably performed using an etching gas mainly containing a chlorine-based gas or a hydrogen-based gas.

As the silicon-containing resist middle layer film in the three-layer resist process, a polysiloxane-based middle layer film is also preferably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides, as a patterning process by way of a four-layer resist process using such a composition for forming a metal-containing film, a patterning process including the steps of:
forming a metal-containing film on a substrate to be processed by using the above-described composition for forming a metal-containing film;
forming a silicon-containing resist middle layer film on the metal-containing film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the metal-containing film by dry etching while using the silicon-containing resist middle layer film having the transferred pattern as a mask; and
processing the substrate to be processed while using the metal-containing film having the formed pattern as a mask, thereby forming the pattern in the substrate to be processed.

Alternatively, an inorganic hard mask may be formed instead of the silicon-containing resist underlayer film. In this case, a semiconductor device circuit pattern can be formed on a substrate, at least, by:
forming a metal-containing film on a body to be processed (substrate to be processed) by using the inventive composition for forming a metal-containing film;
forming an inorganic hard mask middle layer film selected from a silicon oxide film, a silicon nitride film, and a silicon oxynitride film on the metal-containing film;
forming a resist upper layer film on the inorganic hard mask middle layer film by using a photoresist composition;
forming a circuit pattern in the resist upper layer film;
transferring the pattern to the inorganic hard mask middle layer film while using the resist upper layer film having the formed pattern as a mask;
transferring the pattern to the metal-containing film while using the inorganic hard mask middle layer film having the formed pattern as a mask; and
further transferring the pattern to the body to be processed while using the metal-containing film having the formed pattern as a mask to form the pattern in the body to be processed.

The present invention provides, as a patterning process according to a four-layer resist process using the above-described composition for forming a metal-containing film, a patterning process for forming a pattern in a substrate to be processed, including the steps of:
(III-1) applying the above-described composition for forming a metal-containing film onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

As described above, when the inorganic hard mask middle layer film is formed on the metal-containing film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most preferably used as the inorganic hard mask middle layer film. Since the substrate temperature increases to 300 to 500°C when the SiON film is formed, the metal-containing film needs to withstand a temperature of 300 to 500°C. The composition for forming a metal-containing film used in the present invention has high heat resistance and can withstand a high temperature of 300 to 500°C. Thus, the metal-containing film formed by spin-coating and the inorganic hard mask middle layer film formed by the CVD method or the ALD method can be combined.

A photoresist film may be formed on the inorganic hard mask middle layer film as the resist upper layer film as described above. Alternatively, an organic antireflective film (BARC) or an adhesive film may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In addition, the present invention provides a patterning process according to a multilayer resist process using such a composition for forming a metal-containing film. In this case, a semiconductor device circuit pattern can be formed on a substrate by a patterning process for forming a pattern in a substrate to be processed, including the steps of:
(IV-1) forming a resist underlayer film on a substrate to be processed;
(IV-2) applying the above-described composition for forming a metal-containing film onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the organic adhesive film and the metal-containing film or the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

A photoresist film may be formed on the metal-containing film as a resist upper layer film as described above. Alternatively, an organic adhesive film may be formed on the metal-containing film by spin-coating, and a photoresist film may be formed thereon.

As described above, when the resist underlayer film is formed on the substrate to be processed, the resist underlayer film can be formed by a method using a coating-type resist underlayer film material, a CVD method, an ALD method, or the like. Examples of the coating-type resist underlayer film material include resins and compositions disclosed in JP2012-001687A, JP2012-077295A, JP2004-264710A, JP2005-043471A, JP2005-250434A, JP2007-293294A, JP2008-065303A, JP2004-205685A, JP2007-171895A, JP2009-014816A, JP2007-199653A, JP2008-274250A, JP2010-122656A, JP2012-214720A, JP2014-029435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-044022A, etc.

The resist upper layer film in the multilayer resist process described above may be either a positive type or a negative type, and it is possible to use a film similar to the typically used photoresist composition. The prebaking, which is conducted after the spin-coating with the photoresist composition, is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 30 to 500 nm, particularly preferably 50 to 400 nm.

Furthermore, examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask middle layer film in the three-layer resist process is performed while using the resist upper layer film pattern as a mask by using a fluorocarbon-based gas. In this manner, a silicon-containing resist middle layer film pattern or an inorganic hard mask middle layer film pattern is formed.

Next, the metal-containing film is etched while using the obtained silicon-containing resist middle layer film pattern or inorganic hard mask middle layer film pattern as a mask. The etching of the metal-containing film is preferably performed using an etching gas mainly containing a chlorine-based gas.

The subsequent etching of a body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The metal-containing film obtained by using the inventive composition for forming a metal-containing film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process using the inventive composition for forming a metal-containing film, it is preferable to use a substrate to be processed having a structure or step having a height of 30 nm or more. As described above, the inventive composition for forming a metal-containing film has excellent filling and planarizing properties, so that a flat metal-containing film can be formed even when the substrate to be processed has a step (irregularities) or structure having a height of 30 nm or more. The height of the structure or step of the substrate to be processed is preferably 30 nm or more, more preferably 50 nm or more, and more preferably 100 nm or more. In the method of processing a stepped substrate having a pattern of the above-described height, filling and planarizing by forming a film of the inventive composition for forming a metal-containing film makes it possible to achieve a uniform film thickness in the subsequently formed resist middle layer film and resist upper layer film. Therefore, it is easy to ensure the exposure depth margin (DOF) at the time of photolithography, which is very desirable.

### <Tone-Reversal Patterning Process Using Composition for Forming Metal-Containing Film>

Furthermore, the present invention provides, as a tone-reversal patterning process using such a composition for forming a metal-containing film, a tone-reversal patterning process for forming a pattern in a substrate to be processed, including the steps of:
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the above-described composition for forming a metal-containing film onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

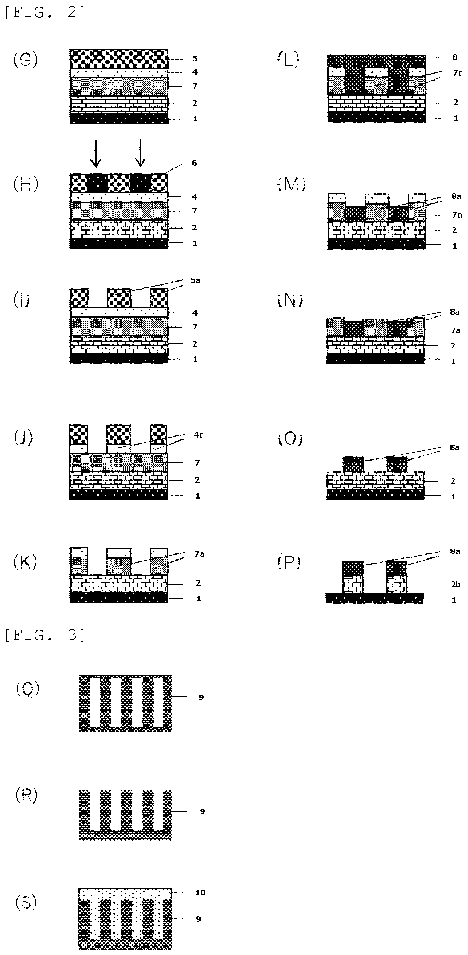

With reference to FIG. 2, a tone-reversal patterning process using a composition for forming a metal-containing film will be described. The present invention provides, as a tone-reversal patterning process using such a composition for forming a metal-containing film, a tone-reversal patterning process including the steps of:
forming a resist underlayer film 7 on a layer 2 to be processed on a substrate 1 to be processed, forming a resist middle layer film 4 or a combination of an inorganic hard mask middle layer film selected from a silicon oxide film, a silicon nitride film, and a silicon oxynitride film and an organic thin film on the resist underlayer film 7, and forming a resist upper layer film 5 on the resist middle layer film 4 or the combination of the inorganic hard mask middle layer film and the organic thin film by using a photoresist material as in FIG. 2(G);
subsequently subjecting an exposure portion 6 of the resist upper layer film to pattern exposure as in FIG. 2(H) and then development with a developer to form a resist upper layer film pattern 5a in the resist upper layer film as in FIG. 2(I);
transferring a resist middle layer film pattern 4a or an inorganic hard mask middle layer film pattern to the resist middle layer film or the organic thin film and the inorganic hard mask middle layer film by dry etching while using the resist upper layer film having the formed pattern as a mask as in FIG. 2(J);
transferring a resist underlayer film pattern 7a to the resist underlayer film by dry etching while using the resist middle layer film or the inorganic hard mask middle layer film having the transferred pattern as a mask as in FIG. 2(K);
covering the resist underlayer film having the formed pattern with a metal-containing film 8 by using the above-described composition for forming a metal-containing film, thereby filling a space between the resist underlayer film patterns 7a with the metal-containing film 8 as in FIG. 2(L);
etching back the metal-containing film covering the resist underlayer film having the formed pattern by a chemical stripper or dry etching to form a reversed metal-containing film pattern 8a to expose an upper surface of the resist underlayer film having the formed pattern as in FIG. 2(M);
removing the resist middle layer film or the hard mask middle layer film remaining on the upper surface of the resist underlayer film pattern 7a by dry etching as in FIG. 2(N);
removing the resist underlayer film having the formed pattern with its surface exposed by dry etching to form a reverse pattern of the original pattern in the metal-containing film as in FIG. 2(O); and
processing the layer to be processed while using the metal-containing film having the formed reverse pattern as a mask to form the reverse pattern 2b in the layer to be processed as in FIG. 2(P).

As described above, when the resist underlayer film is formed on the substrate to be processed, the resist underlayer film can be formed by a method using a coating-type resist underlayer film material, a CVD method, an ALD method, or the like. Examples of the coating-type resist underlayer film material include the resins and compositions given above.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the inorganic hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the tone-reversal patterning process described above, the resist underlayer film pattern preferably has a step or a structure with a height of 30 nm or more. As described above, the inventive composition for forming a metal-containing film has excellent filling and planarizing properties. Thus, even when the film to be processed has a step (irregularities) or a structure with a height of 30 nm or more, a flat metal-containing film can be formed. The height of the structure or the step of the resist underlayer film pattern is preferably 30 nm or more, more preferably 50 nm or more, and still more preferably 100 nm or more. In the method of reversing the resist underlayer film pattern having a pattern with the above-described height, by performing filling and planarization by forming a film from the inventive composition for forming a metal-containing film, inversion/transfer of the pattern can be performed with a high degree of accuracy, which is very desirable. Reversing the resist underlayer film pattern by using the composition for forming a metal-containing film allows a desired resist pattern to be formed on a film to be processed with a high degree of accuracy due to the excellence in resistance in dry etching using a fluorocarbon-based gas relative to the resist underlayer film using a previously-known coating-type resist underlayer film material.

### EXAMPLE

The present invention is more specifically described below with reference to Synthesis Examples, Comparative Synthesis Examples, Examples, and Comparative Examples. However, the present invention is limited to the scope of the claims, only. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### [Synthesis Example]

In the following Synthesis Examples and Comparative Synthesis Examples, the following starting material group G ((G1) to (G13)) was used.

The starting material group G: (G1) to (G13) is shown below.

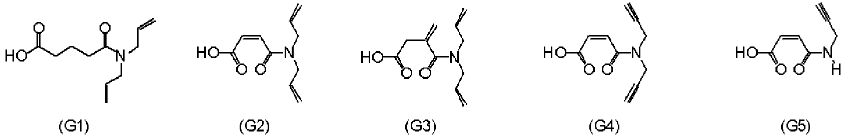

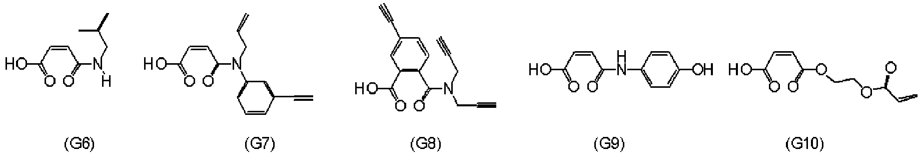

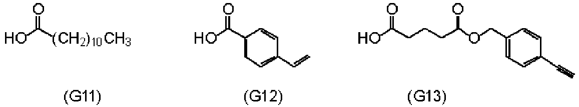

### [Synthesis Example 1] Synthesis of Compound for Forming Metal-Containing Film (A-1)

5.0 g of dibutyltin oxide, 8.5 g of a carboxylic acid (G1), and 100 g of toluene were added together, and refluxed for 7 hours while removing water. After the reaction, the solvent was removed under reduced pressure to give a compound (A-1).

(A-1): Mw = 392, Mw/Mn = 1.03

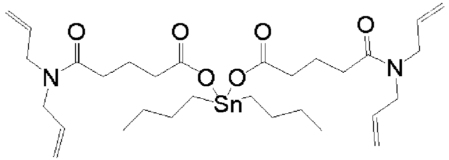

### [Synthesis Examples 2 to 10 and Comparative Synthesis Examples 1 to 3] Synthesis of Compounds (A-2) to (A-10) for Forming Metal-Containing Film and Compounds (R-1) to (R-3) for Comparative Examples

The compounds (A-2) to (A-10) for forming a metal-containing film and the compounds (R-1) to (R-3) for the Comparative Examples shown in Tables 1 to 3 were obtained under the same reaction conditions as in Synthesis Example 1, except that the compound group G and dibutyltin oxide, di-tert-butyltin oxide, dioctyltin oxide, or dibenzyltin oxide were used at the charging amounts shown in Tables 1 to 3. The weight-average molecular weight (Mw) and the dispersity (Mw/Mn) of these compounds were determined. Table 4 shows the results.

**[Table 1]**

| Synthesis Example | Tin oxide compound | Compound group G | Compound for forming metal-containing film |
|---|---|---|---|
| 1 | Dibutyltin oxide 5.0 g | G1 (8.5 g) | 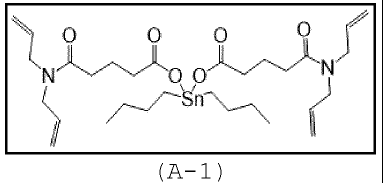 |
| 2 | Dibutyltin oxide 5.0 g | G2 (7.8 g) | 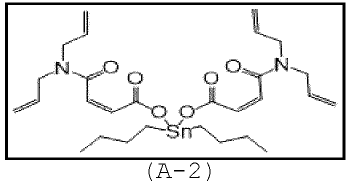 |
| 3 | Di-tert-butyltin oxide 5.0 g | G3 (8.4 g) | 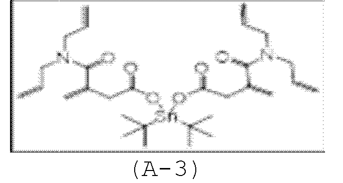 |
| 4 | Dibenzyltin oxide 5.0 g | G4 (6.0 g) | 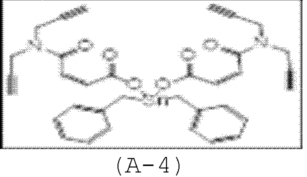 |
| 5 | Dibutyltin oxide 5.0 g | G5 (6.2 g) | 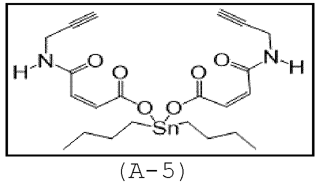 |
| 6 | Dioctyltin oxide 5.0 g | G6 (4.5 g) | 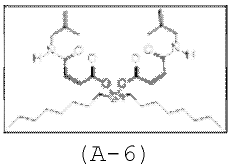 |

**[Table 2]**

| Synthesis Example | Tin oxide compound | Compound group G | Compound for forming metal-containing film |
|---|---|---|---|
| 7 | Dibutyltin oxide 5.0 g | G7 (10.3 g) | 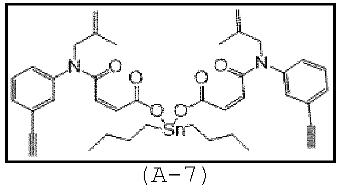 |
| 8 | Dibutyltin oxide 5.0 g | G8 (10.7 g) | 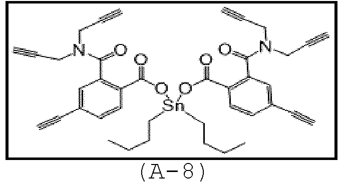 |
| 9 | Dibutyltin oxide 5.0 g | G4 (5.4 g), G9 (2.5 g) | 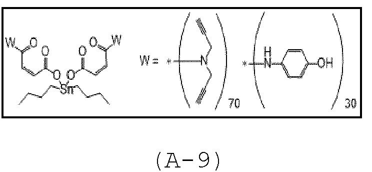 |
| 10 | Dibutyltin oxide 5.0 g | G4 (5.4 g), G10 (2.6 g) | 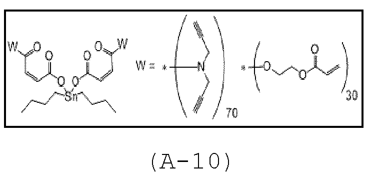 |

**[Table 3]**

| Comparative Synthesis Example | Tin oxide compound | Compound group G | Compound for Comparative Example |
|---|---|---|---|
| 1 | Dibutyltin oxide 5.0 g | G11 (8.0 g) | 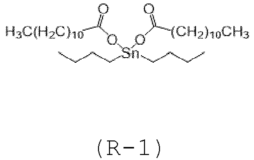 |
| 2 | Dibutyltin oxide 5.0 g | G12 (6.0 g) | 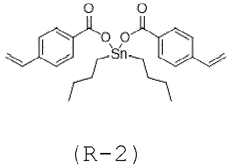 |
| 3 | Dibutyltin oxide 5.0 g | G13 (9.9 g) | 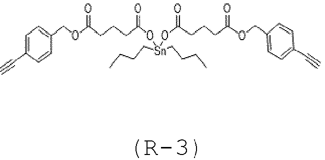 |

**[Table 4]**

| Compound | Mw | Mw/Mn |
|---|---|---|
| A-1 | 392 | 1.03 |
| A-2 | 311 | 1.15 |
| A-3 | 302 | 1.23 |
| A-4 | 324 | 1.13 |
| A-5 | 270 | 1.09 |
| A-6 | 295 | 1.10 |
| A-7 | 337 | 1.04 |
| A-8 | 363 | 1.02 |
| A-9 | 313 | 1.33 |
| A-10 | 332 | 1.40 |
| R-1 | 336 | 1.03 |
| R-2 | 91 | 1.10 |
| R-3 | 313 | 1.24 |

### [Comparative Synthesis Example 4] Synthesis of Compound (R-4) for Comparative Example

8.0 g of butyltin trichloride was stirred at room temperature, and 10 g of acrylic acid was dropped thereto. After that, the temperature was raised to 80°C, and the mixture was stirred for 7 hours. After the completion of the reaction, the acrylic acid was removed under reduced pressure, and (R-4) was obtained.
(R-4): Mw = 51, Mw/Mn = 1.14

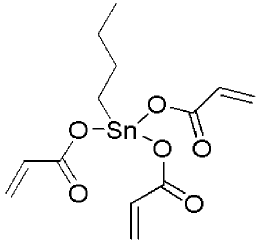

### [Comparative Synthesis Example 5] Synthesis of Compound (R-5) for Comparative Example

As a compound having a different metal from the inventive compound for forming a metal-containing film, a titanium compound reported in [Synthesis Example A-II] of JP6189758B2 was synthesized.

An IPA solution (500 g) of deionized water (27 g) was agitated with an IPA solution (500 g) of a titanium tetraisopropoxide (manufactured by Tokyo Chemical Industry Co., Ltd.) (284 g) and dropped at room temperature for 2 hours. 2-methyl-2,4-pentanediol (120 g) was added to a solution obtained and agitated at room temperature for 30 minutes. After the solution was concentrated under reduced pressure at 30°C, it was heated to 60°C and heating was continued under reduced pressure to generate no distillate. Then, PGMEA (1,200 g) was added thereto and heated under reduced pressure at 40°C until no IPA was distilled to obtain a PGMEA solution of a titanium-containing compound (R-5) (1,000 g) (compound concentration: 20 mass%). The molecular weight of the compound measured in terms of polystyrene was Mw = 1,100.

### [Comparative Synthesis Example 6] Synthesis of Resin (R-6) for Comparative Example

Under a nitrogen atmosphere, 160.2 g of 1,5-dihydroxynaphthalene, 56.8 g of formaldehyde, and 300 g of PGME (propylene glycol monomethyl ether) were added, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the resultant was cooled to room temperature, and 2,000 ml of MIBK was added thereto. The resultant was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-6).

The weight-average molecular weight (Mw) and the dispersity (Mw/Mn) were determined by GPC, and the following results were obtained.
(R-6): Mw = 3,300, Mw/Mn = 2.54

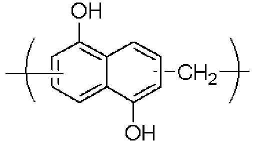

### [Preparation of Composition (UDL-1) for Forming Metal-Containing Film]

The compound (A-1) for forming a metal-containing film was dissolved at a ratio shown in Table 5 in a mixed solvent of propylene glycol monomethyl ether acetate (PGMEA) and cyclohexanone (CyHO) containing 0.5 mass% of a surfactant FC-4430 (manufactured by Sumitomo 3M Limited), and the solution was filtered through a 0.02-µm membrane filter to prepare a composition (UDL-1) for forming a metal-containing film.

### [Preparation of Compositions (UDL-2 to -13) for Forming Metal-Containing Film and Compositions (Comparative UDL-1 to -6) for Forming Metal-Containing Film for Comparative Examples]

Each chemical liquid was prepared in the same manner as UDL-1, except that the type and the contained amount of each component were as shown in Table 5. In Table 5, "-" indicates that the component was not used. The following formula (C-1) was used for the crosslinking agent, the following formula (G-1) was used for the acid generator (TAG), 1,6-diacetoxyhexane (boiling point: 260°C) was used as the high-boiling-point solvent (B-1), and a polymer (F-1) for a flowability accelerator was used as the flowability accelerator.

### [Crosslinking Agent]

The crosslinking agent (C-1) used in a composition for forming a metal-containing film is shown below.

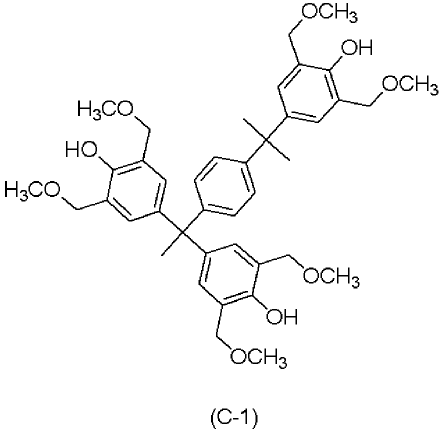

### [Acid Generator]

The acid generator (G-1) used in a composition for forming a metal-containing film is shown below.

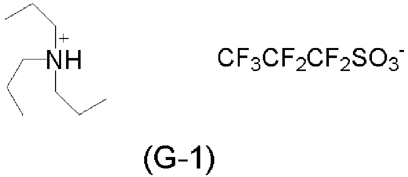

### [Synthesis Example of Polymer for Flowability Accelerator] Synthesis of Polymer (F-1) for Flowability Accelerator

Under a nitrogen atmosphere, 20.0 g of cresol novolak, 27.6 g of potassium carbonate, and 100 g of DMF were added together, and a homogeneous dispersion liquid was prepared at an internal temperature of 50°C. 11.9 g of propargyl bromide was slowly added, followed by a reaction at an internal temperature of 50°C for 24 hours. 300 ml of methylisobutylketone and 300 g of pure water were added to a reaction solution to dissolve the precipitated salts; thereafter, the separated water layer was removed. Further, the organic layer was washed with 100 g of a 3% aqueous nitric acid solution and 100 g of pure water six times, and then the organic layer was dried under reduced pressure to hardness, thereby obtaining a polymer (F-1) for a flowability accelerator.

The weight-average molecular weight (Mw) and the dispersity (Mw/Mn) were determined by GPC, and the following results were obtained.
(F-1): Mw = 8,500, Mw/Mn = 3.46

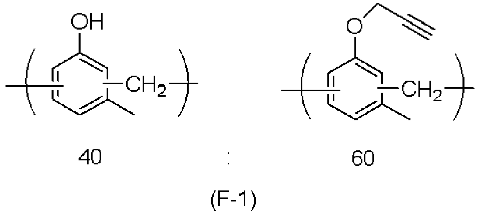

**[Table 5]**

| Composition for forming metal-containing film | Compound for forming metal-containing film | Additive | Solvent |
|---|---|---|---|
| | (parts by mass) | (parts by mass) | (parts by mass) |
| UDL-1 | A-1 (15) | - | PGMEA/CyHO (50/35) |
| UDL-2 | A-2 (15) | - | PGMEA/CyHO (50/35) |
| UDL-3 | A-3 (15) | - | PGMEA/CyHO (50/35) |
| UDL-4 | A-4 (15) | - | PGMEA/CyHO (50/35) |
| UDL-5 | A-5 (15) | - | PGMEA/CyHO (50/35) |
| UDL-6 | A-6 (15) | - | PGMEA/CyHO (50/35) |
| UDL-7 | A-7 (15) | - | PGMEA/CyHO (50/35) |
| UDL-8 | A-8 (15) | - | PGMEA/CyHO (50/35) |
| UDL-9 | A-9 (15) | - | PGMEA/CyHO (50/35) |
| UDL-10 | A-10 (15) | - | PGMEA/CyHO (50/35) |
| UDL-11 | A-2 (15) | F-1(2) | PGMEA/CyHO (50/33) |
| UDL-12 | A-2 (15) | B-1(5) | PGMEA/CyHO (50/30) |
| UDL-13 | A-2 (15) | C-1(3), G-1(3) | PGMEA/CyHO (50/29) |
| Comparative UDL-1 | R-1 (10) | - | PGMEA (90) |
| Comparative UDL-2 | R-2 (15) | - | PGMEA/CyHO (50/35) |
| Comparative UDL-3 | R-3 (15) | - | PGMEA (85) |
| Comparative UDL-4 | R-4 (15) | - | PGMEA/CyHO (50/35) |
| Comparative UDL-5 | R-5 (15) | - | PGMEA(85) |
| Comparative UDL-6 | R-6 (10) | - | PGMEA (90) |

### [Heat Resistance Evaluation and Solvent Resistance Evaluation (Examples 1-1 to 1-13 and Comparative Examples 1-1 to 1-5)]

Each of the compositions (UDL-1 to -13 and comparative UDL-1 to -5) for forming a metal-containing film prepared as described above was respectively applied onto a silicon substrate and baked at 100°C for 60 seconds, and then the film thickness (a [nm]) was measured. Subsequently, after baking at the baking temperature shown in Table 6 for 60 seconds, the film thickness (b [nm]) was measured, and the difference between the film thicknesses (film remaining percentage: (b/a) × 100) before and after the additional baking was determined.

Furthermore, a PGMEA solvent was dispensed thereon, left to stand for 30 seconds, spin-dried, and baked at 100°C for 60 seconds to evaporate the PGMEA. The film thickness (c [nm]) was then measured. The difference between the film thicknesses (film remaining percentage: (c/b) × 100) before and after the PGMEA treatment was determined. The following Table 6 shows the results.

**[Table 6]**

| Example | Composition for forming metal-containing film | Baking temperature | Film thickness a | Baking temperature | Film thickness b | (b/a) × 100 | Film thickness c after rinsing | (c/b) × 100 |
|---|---|---|---|---|---|---|---|---|
| | | °C | nm | °C | nm | % | nm | % |
| Example 1-1 | UDL-1 | 100°C | 190. 7 | 250°C | 88.4 | 47% | 87.9 | 99.4% |
| Example 1-2 | UDL-2 | 100°C | 192.1 | 250°C | 108.6 | 57% | 108.6 | 100.0% |
| Example 1-3 | UDL-3 | 100°C | 200.3 | 250°C | 111.5 | 56% | 111.5 | 100.0% |
| Example 1-4 | UDL-4 | 100°C | 207.4 | 250°C | 105.5 | 51% | 105.5 | 100.0% |
| Example 1-5 | UDL-5 | 100°C | 196.1 | 250°C | 95.9 | 49% | 90.1 | 99. 9% |
| Example 1-6 | UDL-6 | 100°C | 190.6 | 250°C | 85.4 | 45% | 85.2 | 99.8% |
| Example 1-7 | UDL-7 | 100°C | 196.9 | 250°C | 121.3 | 62% | 121.3 | 100.0% |
| Example 1-8 | UDL-8 | 100°C | 195.9 | 250°C | 118.7 | 61% | 118.6 | 99. 9% |
| Example 1-9 | UDL-9 | 100°C | 200.2 | 250°C | 125.4 | 63% | 125.3 | 99.9% |
| Example 1-10 | UDL-10 | 100°C | 204.3 | 250°C | 115.9 | 57% | 115.9 | 100.0% |
| Example 1-11 | UDL-11 | 100°C | 194.4 | 250°C | 110.6 | 57% | 110.6 | 100.0% |
| Example 1-12 | UDL-12 | 100°C | 188.4 | 250°C | 108.6 | 58% | 108.6 | 100.0% |
| Example 1-13 | UDL-13 | 100°C | 198.8 | 250°C | 120.1 | 61% | 120.1 | 100.0% |
| Comparative Example 1-1 | Comparative UDL-1 | 100°C | 201.7 | 250°C | 3.2 | 2% | - | - |
| Comparative Example 1-2 | Comparative UDL-2 | 100°C | 199.7 | 250°C | 1. 8 | 1% | - | - |
| Comparative Example 1-3 | Comparative UDL-3 | 100°C | 236.6 | 250°C | 99.4 | 42% | 94.8 | 95.4% |
| Comparative Example 1-4 | Comparative UDL-4 | 100°C | 176..4 | 250°C | 2.1 | 1% | - | - |
| Comparative Example 1-5 | Comparative UDL-5 | 100°C | 314.4 | 300°C | 81.7 | 26% | 81.75 | 100.0% |

As shown in Table 6, the inventive compositions (Examples 1-1 to 1-13) for forming a metal-containing film had a film remaining percentage ((b/a) × 100) of 45% or more after the additional high-temperature baking, and it was shown that a film that produces little sublimation product can be formed even when compared with Comparative Example 1-3, where a similar composition for forming a metal-containing film was used. Thus, it was shown that the compositions had the high-temperature baking resistance required in resist underlayer films. In addition, the films subjected to additional high-temperature baking had a film remaining percentage ((c/b) × 100) of 99% or more after the PGMEA rinsing, and it can be seen that a crosslinking reaction took place and sufficient solvent resistance was exhibited. It can be considered that these results arise from the fact that the inventive compounds contained a group represented by one of the general formulae (W-1) to (W-4) and had a high crosslinking group density, and therefore, had excellent thermosetting property. In particular, in Examples 1-2 to 1-4 and 1-7, where the composition (UDL-2 to -4 and -7) contained a compound in which the W in the general formula (1) was a group represented by the general formula (W-1) or (W-2) and the X was a group represented by one of the general formulae (2), the film remaining percentage ((b/a) × 100) was 50% or more, and the film remaining percentage ((c/b) × 100) was 100%. It can also be seen that solvent resistance of the same level was also exhibited in the cases where a different kind of carboxylic acid was added to the compound (UDL-9 to -10). On the other hand, comparative UDL-1 did not have a crosslinking group, and therefore, had insufficient heat resistance. Therefore, the film remaining percentage ((b/a) × 100) after the additional high-temperature baking was less than 5%. Meanwhile, in the cases where comparative UDL-2 and comparative UDL-4, having a terminal crosslinking group different from that of the inventive compounds, were used, heat resistance was similarly insufficient, and the film remaining after the high-temperature baking was less than 5 nm.

In Comparative Example 1-5, the composition contained, as a compound having a different metal from the inventive compound for forming a metal-containing film, the titanium compound reported in [Synthesis Example A-II] of JP6189758B2. In this case, sufficient solvent resistance was exhibited, but the difference between the film thicknesses before and after the additional high-temperature baking was large, and it was shown that volume shrinkage due to high-temperature baking was greater than in the inventive compound for forming a metal-containing film.

### [Filling Property Evaluation (Examples 2-1 to 2-13 and Comparative Examples 2-1 to 2-3)]

Each of the compositions (UDL-1 to -13 and comparative UDL-3, -5, and -6) for forming a metal-containing film was respectively applied onto an SiO₂ wafer substrate having a dense line-and-space pattern (line width = 40 nm, line depth = 120 nm, distance between the centers of two adjacent lines = 80 nm), followed by heating at the temperature shown in Table 7 for 60 seconds by using a hot plate to form a metal-containing film having a film thickness of 100 nm. The substrate used was a base substrate 9 (SiO₂ wafer substrate) having a dense line-and-space pattern shown in FIG. 3(Q) (downward view) and (R) (cross-sectional view). The cross-sectional shape of each of the obtained wafer substrates was observed using an electron microscope (S-4700: manufactured by Hitachi, Ltd.), and the presence/absence of voids (gaps) inside the metal-containing film filling the space between the lines was confirmed. Table 7 shows the results. In this evaluation, when a composition for forming a metal-containing film having a poor filling property is used, a stepped substrate cannot be filled successfully. In this evaluation, when a composition for forming a metal-containing film having a desirable filling property is used, as shown in FIG. 3(S), the space between the lines of the base substrate 9 having the dense line-and-space pattern can be filled with a metal-containing film 10 without gaps. "Good" indicates that filling was possible without large voids, "Poor" indicates that voids were visible, and "Bad" indicates that filling was not possible.

**[Table 7]**

| Example | Composition for forming metal-containing film | Baking temperature | Filling property |
|---|---|---|---|
| | | °C | |
| Example 2-1 | UDL-1 | 250°C | Good |
| Example 2-2 | UDL-2 | 250°C | Good |
| Example 2-3 | UDL-3 | 250°C | Good |
| Example 2-4 | UDL-4 | 250°C | Good |
| Example 2-5 | UDL-5 | 250°C | Good |
| Example 2-6 | UDL-6 | 250°C | Good |
| Example 2-7 | UDL-7 | 250°C | Good |
| Example 2-8 | UDL-8 | 250°C | Good |
| Example 2-9 | UDL-9 | 250°C | Good |
| Example 2-10 | UDL-10 | 250°C | Good |
| Example 2-11 | UDL-11 | 250°C | Good |
| Example 2-12 | UDL-12 | 250°C | Good |
| Example 2-13 | UDL-13 | 250°C | Good |
| Comparative Example 2-1 | Comparative UDL-3 | 250°C | Good |
| Comparative Example 2-2 | Comparative UDL-5 | 300°C | Poor |
| Comparative Example 2-3 | Comparative UDL-6 | 300°C | Good |

It was successfully confirmed that, as shown in Table 7, in Examples 2-1 to 2-13 using the inventive compositions (UDL-1 to -13) for forming a metal-containing film and in Comparative Example 2-1 using a similar composition (comparative UDL-3) for forming a metal-containing film, it was possible to fill the dense line-and-space pattern without the generation of voids, and excellent filling property was provided. On the other hand, voids were observed at the bottom of the pattern in Comparative Example 2-2, using the titanium compound reported in [Synthesis Example A-II] of JP6189758B2. It is conjectured that voids were generated because volume shrinkage due to high-temperature baking was great, as observed in the solvent resistance evaluation. In Comparative Example 2-3, using comparative UDL-6, it was possible to fill the dense line-and space pattern without voids being generated.

### [Planarizing Property Evaluation (Examples 3-1 to 3-13 and Comparative Examples 3-1 to 3-3)]

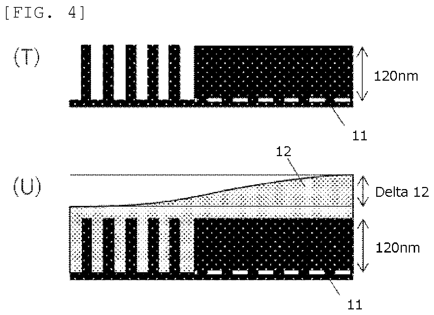

Regarding base substrates 11 (SiO₂ wafer substrates) each having a dense line-and-space pattern shown in FIG. 4(T), the cross sectional shape of each of the wafer substrates obtained in the filling property evaluation as shown in FIG. 4(U) was observed using a scanning electron microscope (SEM), and the step (Delta 12 in FIG. 4(U)) between the line-pattern-dense portion and the non-line-pattern portion of the filling film 12 was observed using an electron microscope (S-4700: manufactured by Hitachi, Ltd.). Table 8 shows the results. In the present evaluation, it can be said that the smaller the step, the better the planarizing property.

**[Table 8]**

| Example | Composition for forming metal-containing film | Baking temperature | Flatness |
|---|---|---|---|
| | | °C | nm |
| Example 3-1 | UDL-1 | 250°C | 33 |
| Example 3-2 | UDL-2 | 250°C | 32 |
| Example 3-3 | UDL-3 | 250°C | 32 |
| Example 3-4 | UDL-4 | 250°C | 31 |
| Example 3-5 | UDL-5 | 250°C | 35 |
| Example 3-6 | UDL-6 | 250°C | 34 |
| Example 3-7 | UDL-7 | 250°C | 31 |
| Example 3-8 | UDL-8 | 250°C | 32 |
| Example 3-9 | UDL-9 | 250°C | 30 |
| Example 3-10 | UDL-10 | 250°C | 28 |
| Example 3-11 | UDL-11 | 250°C | 26 |
| Example 3-12 | UDL-12 | 250°C | 27 |
| Example 3-13 | UDL-13 | 250°C | 32 |
| Comparative Example 3-1 | Comparative UDL-3 | 250°C | 31 |
| Comparative Example 3-2 | Comparative UDL-5 | 300°C | 57 |
| Comparative Example 3-3 | Comparative UDL-6 | 350°C | 49 |

As shown in Table 8, it was observed that the step in the film between the patterned portion and the non-patterned portion was small and the planarization property was better in Examples 3-1 to 3-13, where the inventive compositions (UDL-1 to -13) for forming a metal-containing film were used, than in Comparative Example 3-2, where comparative UDL-5, an organic resist underlayer film material, was used or in Comparative Example 3-3, where comparative UDL-6, containing the resin (R-6), was used. Thus, it can be seen that thermal flowability is improved when the structure of the general formula (1) is included, and therefore, excellent planarizing property is exhibited. In particular, even better planarizing property was exhibited in Example 3-10, where the used composition (UDL-10) for forming a metal-containing film contained A-10, synthesized by mixing in a different carboxylic acid having a long alkyl chain. Meanwhile, in Examples 3-11 and 3-12, where compositions (UDL-11 and -12) for forming a metal-containing film containing a high-boiling-point solvent (B-1) and a flowability accelerator (F-1) were used, planarizing property was greatly improved compared to Example 3-2, where the additives were not contained. Thus, it can be observed that the thermal flowability of a compound for forming a metal-containing film can be improved further by using these additives.

### [Etching Resistance Evaluation (Examples 4-1 to 4-13 and Comparative Examples 4-1 to 4-3)]

Each of the compositions (UDL-1 to -13 and comparative UDL-3, -5, and -6) for forming a metal-containing film was respectively applied onto a silicon substrate and heated by using a hot plate at the temperature shown in Table 9 for 60 seconds to form a metal-containing film having a film thickness of 100 nm, and the film thickness A was measured. Subsequently, etching was performed with CF₄ gas, O₂ gas, and Cl₂ gas under the following conditions for the specified number of seconds by using an etching apparatus CE-300I manufactured by ULVAC, Inc., and the film thickness B was measured. Then, the film thickness etched in 1 minute was calculated as etching rate (nm/min) from the film thickness etched in the respective number of seconds ("film thickness B" - "film thickness A"). Table 9 shows the results.

### Conditions of dry etching with CF₄ gas

Pressure: 1 Pa
Antenna RF power: 100 W
Bias RF power: 15 W
CF₄ gas flow rate: 15 sccm
Time: 30 sec

### Conditions of dry etching with O₂ gas

Pressure: 1 Pa
Antenna RF power: 300 W
Bias RF power: 0 W
O₂ gas flow rate: 25 sccm
Time: 20 sec

### Conditions of dry etching with Cl₂ gas

Pressure: 1 Pa
Antenna RF power: 320 W
Bias RF power: 30 W
Cl₂ gas flow rate: 25 sccm
Time: 10 sec

**[Table 9]**

| Example | Composition for forming metal-containing film | Baking temperature | Etching rate (nm/min) | | |
|---|---|---|---|---|---|
| | | °C | CF₄ | O₂ | Cl₂ |
| Example 4-1 | UDL-1 | 250°C | 31 | 6 | 530 |
| Example 4-2 | UDL-2 | 250°C | 27 | 8 | 520 |
| Example 4-3 | UDL-3 | 250°C | 30 | 9 | 520 |
| Example 4-4 | UDL-4 | 250°C | 30 | 7 | 510 |
| Example 4-5 | UDL-5 | 250°C | 32 | 11 | 520 |
| Example 4-6 | UDL-6 | 250°C | 31 | 6 | 520 |
| Example 4-7 | UDL-7 | 250°C | 30 | 9 | 510 |
| Example 4-8 | UDL-8 | 250°C | 31 | 7 | 510 |
| Example 4-9 | UDL-9 | 250°C | 26 | 8 | 520 |
| Example 4-10 | UDL-10 | 250°C | 33 | 8 | 510 |
| Example 4-11 | UDL-11 | 250°C | 34 | 8 | 550 |
| Example 4-12 | UDL-12 | 250°C | 32 | 11 | 500 |
| Example 4-13 | UDL-13 | 250°C | 27 | 8 | 510 |
| Comparative Example 4-1 | Comparative UDL-3 | 250°C | 29 | 8 | 520 |
| Comparative Example 4-2 | Comparative UDL-5 | 300°C | 30 | 10 | 105 |
| Comparative Example 4-3 | Comparative UDL-6 | 350°C | 65 | 210 | 130 |

As shown in Table 9, it was shown that better CF₄ etching resistance and O₂ etching resistance were exhibited in Examples 4-1 to 4-13, where the inventive compositions (UDL-1 to -13) for forming a metal-containing film were used, than in Comparative Example 4-3, where comparative UDL-6, containing the resin (R-6), was used. In addition, it was revealed that, while the compositions showed excellent resistance to etching with CF₄ gas and O₂ gas, the compositions exhibited excellent removability by etching with Cl₂ gas.

### [Patterning Process (Examples 5-1 to 5-13 and Comparative Examples 5-1 and 5-2)]

Each of the compositions (UDL-1 to -13 and comparative UDL-5 and -6) for forming a metal-containing film was respectively applied onto an SiO₂ wafer substrate having a trench pattern (trench width: 10 µm, trench depth: 0.10 µm), and baked at 250°C for 60 seconds in the atmosphere to form a metal-containing film having a thickness of 100 nm. A silicon-containing resist middle layer film material (SOG-1) was applied thereto, followed by baking at 220°C for 60 seconds to form a resist middle layer film having a thickness of 30 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

The silicon-containing resist middle layer film material (SOG-1) was prepared by dissolving a polymer represented by an ArF silicon-containing middle layer film polymer (SiP1) and a thermal crosslinking catalyst (CAT1) in an organic solvent containing 0.1 mass% of FC-4430 (manufactured by Sumitomo 3M Limited) in the proportion shown in Table 10; and filtering the solution through a filter made of a fluororesin and having a pore size of 0.1 µm.

**[Table 10]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the of the ArF silicon-containing middle layer film polymer (SiP1) and the thermal crosslinking catalyst (CAT1) used are shown below.

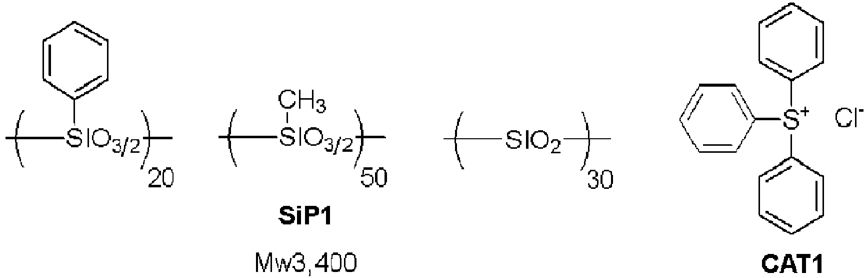

The resist upper layer film material (monolayer resist for ArF) was prepared by dissolving a polymer (RP1), an acid generator (PAG1), and a basic compound (Amine1), each in the proportion shown in Table 11, in a solvent containing 0.1% by mass of a surfactant (FC-4430: manufactured by Sumitomo 3M Limited), and filtering the solution through a 0.1-µm filter made of a fluororesin.

**[Table 11]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

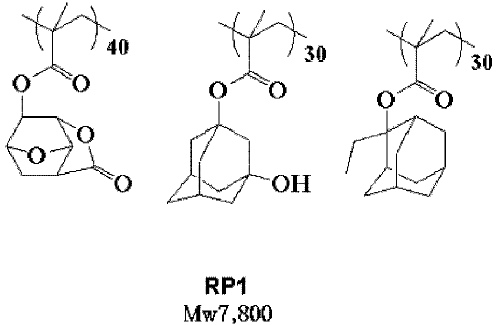

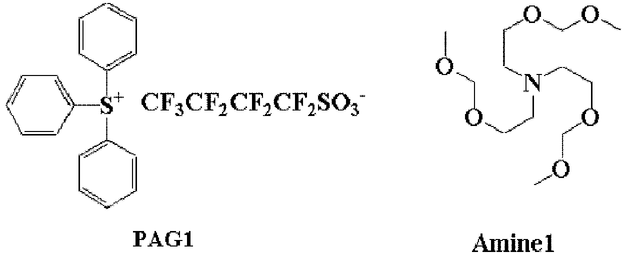

The liquid immersion top coat composition (TC-1) was prepared by dissolving a top coat polymer (PP1) in an organic solvent at the proportion shown in Table 12, and filtering the solution through a 0.1-µm filter made of a fluororesin.

**[Table 12]**

| | Top coat polymer (parts by mass) | Organic solvent (parts by mass) |
|---|---|---|
| TC-1 | PP1 (100) | Diisoamyl ether (2,700) 2-methyl-1-butanol (270) |

The top coat polymer (PP1) used for the liquid immersion top coat composition (TC-1) is shown below.

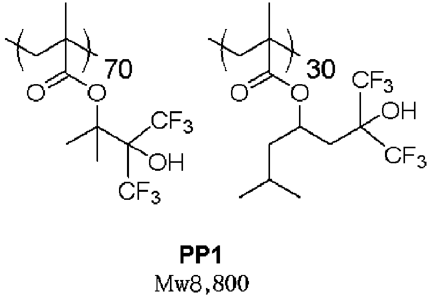

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the resist middle layer film was etched by dry etching while using the resist upper layer film pattern as a mask to form a hard mask pattern. The metal-containing film was then etched while using the obtained hard mask pattern as a mask to form a metal-containing film pattern, and the SiO₂ film was etched while using the obtained metal-containing film pattern as a mask. The etching conditions were as follows.

### Conditions in transferring resist upper layer film pattern to resist middle layer film

### Conditions of dry etching with CF₄ gas

Pressure: 1 Pa
Antenna RF power: 100 W
Bias RF power: 15 W
CF₄ gas flow rate: 15 sccm
Time: 60 sec

### Conditions in transferring hard mask pattern to metal-containing film

Pressure: 1 Pa
Antenna RF power: 320 W
Bias RF power: 30 W
Cl₂ gas flow rate: 25 sccm
Time (Example 5-1 to Example 5-13): 15 sec
Time (Comparative Example 5-1 and Comparative Example 5-2): 60 sec

### Conditions in transferring metal-containing film pattern to SiO₂ film

### Conditions of dry etching with CF₄ gas

Pressure: 1 Pa
Antenna RF power: 100 W
Bias RF power: 15 W
CF₄ gas flow rate: 15 sccm
Time: 60 sec

Table 13 shows the results obtained by observation of the pattern cross section with an electron microscope (S-4700) manufactured by Hitachi, Ltd.

**[Table 13]**

| Example | Composition for forming metal-containing film | Pattern profile after etching for transferring to substrate |
|---|---|---|
| Example 5-1 | UDL-1 | Vertical profile |
| Example 5-2 | UDL-2 | Vertical profile |
| Example 5-3 | UDL-3 | Vertical profile |
| Example 5-4 | UDL-4 | Vertical profile |
| Example 5-5 | UDL-5 | Vertical profile |
| Example 5-6 | UDL-6 | Vertical profile |
| Example 5-7 | UDL-7 | Vertical profile |
| Example 5-8 | UDL-8 | Vertical profile |
| Example 5-9 | UDL-9 | Vertical profile |
| Example 5-10 | UDL-10 | Vertical profile |
| Example 5-11 | UDL-11 | Vertical profile |
| Example 5-12 | UDL-12 | Vertical profile |
| Example 5-13 | UDL-13 | Vertical profile |
| Comparative Example 5-1 | Comparative UDL-5 | Pattern collapse |
| Comparative Example 5-2 | Comparative UDL-6 | Distorted pattern |

As shown in Table 13, in Examples 5-1 to 5-13, where the compositions (UDL-1 to -13) of the present invention for forming a metal-containing film were used, the resist upper layer film pattern was successfully transferred to the substrate in the end in every case. Thus, it was confirmed that the composition of the present invention for forming a metal-containing film can be used suitably for fine processing using a multilayer resist method. On the other hand, in Comparative Example 5-1, using comparative UDL-5, where the performance in the filling property evaluation and the planarizing property evaluation was found to be insufficient, pattern collapse occurred during patterning, and it was not possible to obtain a favorable pattern in the end. Meanwhile, in Comparative Example 5-2, using comparative UDL-6, where there were no problems in the filling property but insufficient performance was observed in the planarizing property evaluation and the dry etching resistance evaluation, distortion of the pattern profile occurred at the time of pattern processing, and it was not possible to obtain a favorable pattern in the end.

From the above, the compound of the present invention for forming a metal-containing film is an organotin compound having both high thermal flowability and high thermosetting property, so that a composition for forming a metal-containing film containing the compound can provide a resist underlayer film material having better dry etching resistance than conventional resist underlayer film materials and also having high filling and planarizing properties. Therefore, such a composition is extremely useful as a resist underlayer film material used in a multilayer resist method and an inverting agent used in a tone-reversal etching method.

It should be noted that the present invention is not limited to the above-described embodiments. The embodiments are just examples, and any examples that fall within the definition of the claims are included in the technical scope of the present invention.

## Claims

1. A compound for forming a metal-containing film to be contained in a composition for forming a metal-containing film, wherein the compound is represented by the following general formula (M),
Tₙ-Sn-Qₘ (M)
wherein T represents a group represented by the following general formula (1) or a group represented by the following general formula (1'), at least one T representing a group represented by the following general formula (1) and T optionally being one kind or a combination of two or more kinds; Q represents a substituted or unsubstituted alkyl group having 1 to 20 carbon atoms, a substituted or unsubstituted cycloalkyl group having 3 to 20 carbon atoms, a substituted or unsubstituted aliphatic unsaturated organic group having 2 to 20 carbon atoms and having one or more double bonds or triple bonds, a substituted or unsubstituted aryl group having 6 to 30 carbon atoms, a substituted or unsubstituted arylalkyl group having 7 to 31 carbon atoms, or a combination of these groups; and "m" and "n" represent any integer, provided that "m" and "n" satisfy the relationship m+n = 4, m ≥ 1, and n ≥ 2, 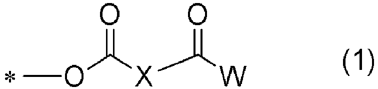 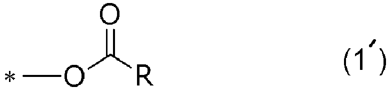
wherein X represents a divalent organic group having 1 to 31 carbon atoms, W represents a group represented by one of the following general formulae (W-1) to (W-4), and "*" represents an attachment point to a Sn atom in the general formula (1); and R represents any substituent and "*" represents an attachment point to a Sn atom in the general formula (1'), 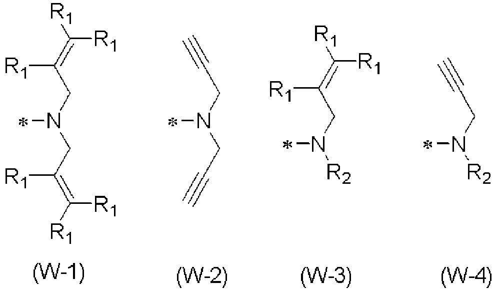
wherein R₁'s each represent a hydrogen atom or a methyl group and are identical to or different from each other in the general formulae (W-1) and (W-3); and R₂ represents a hydrogen atom, a substituted or unsubstituted saturated monovalent organic group having 1 to 20 carbon atoms or a substituted or unsubstituted unsaturated monovalent organic group having 2 to 20 carbon atoms, a substituted or unsubstituted aryl group having 6 to 30 carbon atoms, or a substituted or unsubstituted arylalkyl group having 7 to 31 carbon atoms in (W-3) and (W-4), and "*" represents an attachment point to a carbonyl group.

2. The compound for forming a metal-containing film according to claim 1, wherein the X in the general formula (1) represents an unsaturated hydrocarbon group having 2 to 20 carbon atoms.

3. The compound for forming a metal-containing film according to claim 2, wherein the X in the general formula (1) represents a group represented by one of the following general formulae (2), 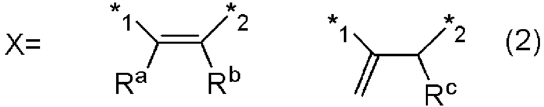 wherein R^{a} and R^{b} each represent a hydrogen atom or a monovalent organic group having 1 to 18 carbon atoms; R^{c} represents a hydrogen atom or a monovalent organic group having 1 to 17 carbon atoms; R^{a} and R^{b} have a total of 0 to 18 carbon atoms, R^{a} and R^{b} optionally being bonded to each other to form a cyclic substituent; and "*1" and "*2" each represent an attachment point to a carbonyl group, "*1" and "*2" optionally being reversed.

4. The compound for forming a metal-containing film according to any one of claims 1 to 3, wherein the compound for forming a metal-containing film satisfies 1.00 ≤ Mw/Mn ≤ 1.50, where Mw is a weight-average molecular weight and Mn is a number-average molecular weight measured by gel permeation chromatography in terms of polystyrene.

5. A composition for forming a metal-containing film used in manufacturing a semiconductor, the composition comprising: (A) the compound for forming a metal-containing film according to any one of claims 1 to 4; and (B) an organic solvent.

6. The composition for forming a metal-containing film according to claim 5, further comprising one or more of (C) a crosslinking agent, (E) a surfactant, (F) a flowability accelerator, and (G) an acid generator.

7. The composition for forming a metal-containing film according to claim 5 or 6, wherein the organic solvent (B) contains, as (B1) a high-boiling-point solvent, one or more kinds of organic solvent having a boiling point of 180°C or higher.

8. A patterning process for forming a pattern in a substrate to be processed, comprising the steps of:
(I-1) applying the composition for forming a metal-containing film according to any one of claims 5 to 7 onto a substrate to be processed, followed by heating to form a metal-containing film;
(I-2) forming a resist upper layer film on the metal-containing film by using a photoresist material;
(I-3) subjecting the resist upper layer film to pattern exposure and then development with a developer to form a pattern in the resist upper layer film;
(I-4) transferring the pattern to the metal-containing film by dry etching while using the resist upper layer film having the formed pattern as a mask; and
(I-5) processing the substrate to be processed while using the metal-containing film having the formed pattern as a mask to form the pattern in the substrate to be processed.

9. A patterning process for forming a pattern in a substrate to be processed, comprising the steps of:
(II-1) applying the composition for forming a metal-containing film according to any one of claims 5 to 7 onto a substrate to be processed, followed by heating to form a metal-containing film;
(II-2) forming a silicon-containing resist middle layer film on the metal-containing film;
(II-3) forming a resist upper layer film on the silicon-containing resist middle layer film by using a photoresist material;
(II-4) subjecting the resist upper layer film to pattern exposure and then development with a developer to form a pattern in the resist upper layer film;
(II-5) transferring the pattern to the silicon-containing resist middle layer film by dry etching while using the resist upper layer film having the formed pattern as a mask;
(II-6) transferring the pattern to the metal-containing film by dry etching while using the silicon-containing resist middle layer film having the transferred pattern as a mask; and
(II-7) processing the substrate to be processed while using the metal-containing film having the formed pattern as a mask to form the pattern in the substrate to be processed.

10. A patterning process for forming a pattern in a substrate to be processed, comprising the steps of:
(III-1) applying the composition for forming a metal-containing film according to any one of claims 5 to 7 onto a substrate to be processed, followed by heating to form a metal-containing film;
(III-2) forming an inorganic hard mask middle layer film selected from a silicon oxide film, a silicon nitride film, and a silicon oxynitride film on the metal-containing film;
(III-3) forming an organic thin film on the inorganic hard mask middle layer film;
(III-4) forming a resist upper layer film on the organic thin film by using a photoresist material;
(III-5) subjecting the resist upper layer film to pattern exposure and then development with a developer to form a pattern in the resist upper layer film;
(III-6) transferring the pattern to the organic thin film and the inorganic hard mask middle layer film by dry etching while using the resist upper layer film having the formed pattern as a mask;
(III-7) transferring the pattern to the metal-containing film by dry etching while using the inorganic hard mask middle layer film having the transferred pattern as a mask; and
(III-8) processing the substrate to be processed while using the metal-containing film having the formed pattern as a mask to form the pattern in the substrate to be processed.

11. The patterning process according to claim 10, wherein the inorganic hard mask middle layer film is formed by a CVD method or an ALD method.

12. A patterning process for forming a pattern in a substrate to be processed, comprising the steps of:
(IV-1) forming a resist underlayer film on a substrate to be processed;
(IV-2) applying the composition for forming a metal-containing film according to any one of claims 5 to 7 onto the resist underlayer film, followed by heating to form a metal-containing film;
(IV-3) forming a resist upper layer film on the metal-containing film by using a photoresist material or forming an organic adhesive film on the metal-containing film by spin-coating and forming a resist upper layer film on the organic adhesive film by using a photoresist material;
(IV-4) subjecting the resist upper layer film to pattern exposure and then development with a developer to form a pattern in the resist upper layer film;
(IV-5) transferring the pattern to the organic adhesive film and the metal-containing film or the metal-containing film by dry etching while using the resist upper layer film having the formed pattern as a mask;
(IV-6) transferring the pattern to the resist underlayer film by dry etching while using the metal-containing film having the transferred pattern as a mask; and
(IV-7) processing the substrate to be processed while using the resist underlayer film having the formed pattern as a mask to form the pattern in the substrate to be processed.

13. A tone-reversal patterning process for forming a pattern in a substrate to be processed, comprising the steps of:
(V-1) forming a resist underlayer film on a substrate to be processed;
(V-2) forming a resist middle layer film or a combination of an inorganic hard mask middle layer film selected from a silicon oxide film, a silicon nitride film, and a silicon oxynitride film and an organic thin film on the resist underlayer film;
(V-3) forming a resist upper layer film on the resist middle layer film or the combination of the inorganic hard mask middle layer film and the organic thin film by using a photoresist material;
(V-4) subjecting the resist upper layer film to pattern exposure and then development with a developer to form a pattern in the resist upper layer film;
(V-5) transferring the pattern to the resist middle layer film or the organic thin film and the inorganic hard mask middle layer film by dry etching while using the resist upper layer film having the formed pattern as a mask;
(V-6) transferring the pattern to the resist underlayer film by dry etching while using the resist middle layer film or the inorganic hard mask middle layer film having the transferred pattern as a mask;
(V-7) applying the composition for forming a metal-containing film according to any one of claims 5 to 7 onto the resist underlayer film having the formed pattern, followed by heating to cover the resist underlayer film with a metal-containing film, thereby filling a space between the resist underlayer film patterns with the metal-containing film;
(V-8) etching back the metal-containing film covering the resist underlayer film having the formed pattern by a chemical stripper or dry etching to expose an upper surface of the resist underlayer film having the formed pattern;
(V-9) removing the resist middle layer film or the inorganic hard mask middle layer film remaining on the upper surface of the resist underlayer film by dry etching;
(V-10) removing the resist underlayer film having the formed pattern with its surface exposed by dry etching to form a reverse pattern of an original pattern on the metal-containing film; and
(V-11) processing the substrate to be processed while using the metal-containing film having the formed reverse pattern as a mask to form the reverse pattern in the substrate to be processed.

## Patentansprüche

1. Verbindung zur Bildung eines metallhaltigen Films, die in einer Zusammensetzung zur Bildung eines metallhaltigen Films enthalten ist, wobei die Verbindung durch die folgende allgemeine Formel (M) dargestellt wird,
Tₙ-Sn-Qₘ **(M)**
wobei T eine Gruppe der folgenden allgemeinen Formel (1) oder eine Gruppe der folgenden allgemeinen Formel (1') darstellt, wobei mindestens ein T eine Gruppe der folgenden allgemeinen Formel (1) darstellt und T optional eine Art oder eine Kombination aus zwei oder mehr Arten sein kann; Q eine substituierte oder unsubstituierte Alkylgruppe mit 1 bis 20 Kohlenstoffatomen, eine substituierte oder unsubstituierte Cycloalkylgruppe mit 3 bis 20 Kohlenstoffatomen, eine substituierte oder unsubstituierte aliphatische ungesättigte organische Gruppe mit 2 bis 20 Kohlenstoffatomen und einer oder mehreren Doppelbindungen oder Dreifachbindungen, eine substituierte oder unsubstituierte Arylgruppe mit 6 bis 30 Kohlenstoffatomen, eine substituierte oder unsubstituierte Arylalkylgruppe mit 7 bis 31 Kohlenstoffatomen oder eine Kombination dieser Gruppen darstellt; und "m" und "n" für eine beliebige ganze Zahl stehen, vorausgesetzt, dass "m" und "n" die Beziehung m+n = 4, m ≥ 1 und n ≥ 2 erfüllen, 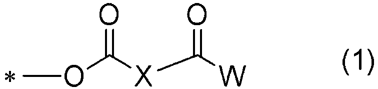 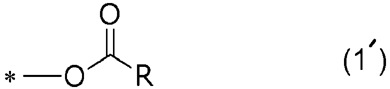
wobei X eine zweiwertige organische Gruppe mit 1 bis 31 Kohlenstoffatomen darstellt, W eine Gruppe darstellt, die durch eine der folgenden allgemeinen Formeln (W-1) bis (W-4) dargestellt wird, und "*" einen Bindungspunkt an ein Sn-Atom in der allgemeinen Formel (1) darstellt; und R einen beliebigen Substituenten darstellt und "*" einen Bindungspunkt an ein Sn-Atom in der allgemeinen Formel (1') darstellt, 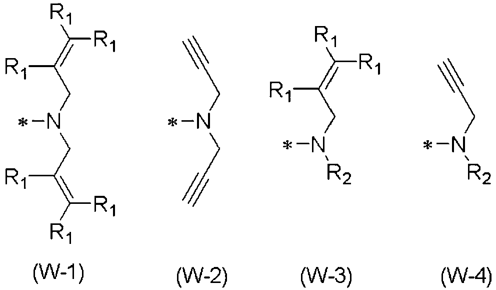
wobei R₁ jeweils ein Wasserstoffatom oder eine Methylgruppe darstellt und in den allgemeinen Formeln (W-1) und (W-3) identisch oder voneinander verschieden ist; und R₂ ein Wasserstoffatom, eine substituierte oder unsubstituierte gesättigte einwertige organische Gruppe mit 1 bis 20 Kohlenstoffatomen oder eine substituierte oder unsubstituierte ungesättigte einwertige organische Gruppe mit 2 bis 20 Kohlenstoffatomen, eine substituierte oder unsubstituierte Arylgruppe mit 6 bis 30 Kohlenstoffatomen oder eine substituierte oder unsubstituierte Arylalkylgruppe mit 7 bis 31 Kohlenstoffatomen in (W-3) und (W-4) darstellt, und "*" einen Bindungspunkt an eine Carbonylgruppe darstellt.

2. Verbindung zur Bildung eines metallhaltigen Films gemäß Anspruch 1, wobei das X in der allgemeinen Formel (1) eine ungesättigte Kohlenwasserstoffgruppe mit 2 bis 20 Kohlenstoffatomen darstellt.

3. Verbindung zur Bildung eines metallhaltigen Films gemäß Anspruch 2, wobei das X in der allgemeinen Formel (1) eine Gruppe darstellt, die durch eine der folgenden allgemeinen Formeln (2) dargestellt wird, 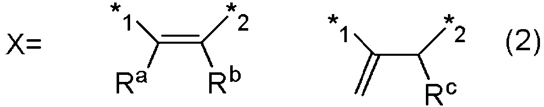 wobei R^{a} und R^{b} jeweils ein Wasserstoffatom oder eine einwertige organische Gruppe mit 1 bis 18 Kohlenstoffatomen darstellen; R^{c} ein Wasserstoffatom oder eine einwertige organische Gruppe mit 1 bis 17 Kohlenstoffatomen darstellt; R^{a} und R^{b} insgesamt 0 bis 18 Kohlenstoffatome aufweisen, wobei R^{a} und R^{b} optional miteinander verbunden sind, um einen cyclischen Substituenten zu bilden; und "*1" und "*2" jeweils einen Bindungspunkt an eine Carbonylgruppe darstellen, wobei "*1" und "*2" optional vertauscht sein können.

4. Verbindung zur Bildung eines metallhaltigen Films gemäß einem der Ansprüche 1 bis 3, wobei die Verbindung zur Bildung eines metallhaltigen Films 1,00 ≤ Mw/Mn ≤ 1,50 erfüllt, wobei Mw das gewichtsmittlere Molekulargewicht und Mn das zahlenmittlere Molekulargewicht ist, gemessen durch Gelpermeationschromatographie in Bezug auf Polystyrol.

5. Zusammensetzung zur Bildung eines metallhaltigen Films, die bei der Herstellung eines Halbleiters verwendet wird, wobei die Zusammensetzung umfasst: (A) die Verbindung zur Bildung eines metallhaltigen Films gemäß einem der Ansprüche 1 bis 4; und (B) ein organisches Lösungsmittel.

6. Zusammensetzung zur Bildung eines metallhaltigen Films gemäß Anspruch 5, ferner umfassend eines oder mehrere von (C) einem Vernetzungsmittel, (E) einem Tensid, (F) einem Fließbeschleuniger und (G) einem Säuregenerator.

7. Zusammensetzung zur Bildung eines metallhaltigen Films gemäß Anspruch 5 oder 6, wobei das organische Lösungsmittel (B) als (B1) ein hochsiedendes Lösungsmittel enthält, wobei eine oder mehrere Arten von organischen Lösungsmitteln einen Siedepunkt von 180 °C oder höher haben.

8. Verfahren zum Strukturieren eines zu bearbeitenden Substrats, umfassend die folgenden Schritte:
(I-1) Aufbringen der Zusammensetzung zur Bildung eines metallhaltigen Films gemäß einem der Ansprüche 5 bis 7 auf ein zu bearbeitendes Substrat, gefolgt von Erhitzen, um einen metallhaltigen Film zu bilden;
(I-2) Ausbilden eines Resist-Oberschichtfilms auf dem metallhaltigen Film unter Verwendung eines Fotoresistmaterials;
(I-3) Unterziehen des Resist-Oberschichtfilms einer Strukturbelichtung und anschließendes Entwickeln mit einem Entwickler, um eine Struktur in dem Resist-Oberschichtfilm zu bilden;
(I-4) Übertragen der Struktur auf den metallhaltigen Film durch Trockenätzen unter Verwendung des Resist-Oberschichtfilms mit der gebildeten Struktur als Maske; und
(I-5) Bearbeiten des zu bearbeitenden Substrats unter Verwendung des metallhaltigen Films mit der gebildeten Struktur als Maske, um die Struktur in dem zu bearbeitenden Substrat zu bilden.

9. Verfahren zum Strukturieren eines zu bearbeitenden Substrats, umfassend die folgenden Schritte:
(II-1) Aufbringen der Zusammensetzung zur Bildung eines metallhaltigen Films gemäß einem der Ansprüche 5 bis 7 auf ein zu bearbeitendes Substrat, gefolgt von Erhitzung, um einen metallhaltigen Film zu bilden;
(II-2) Ausbilden eines siliziumhaltigen Resist-Mittelschichtfilms auf dem metallhaltigen Film;
(II-3) Ausbilden eines Resist-Oberschichtfilms auf dem siliziumhaltigen Resist-Mittelschichtfilm unter Verwendung eines Fotoresistmaterials;
(II-4) Unterziehen des Resist-Oberschichtfilms einer Strukturbelichtung und anschließendes Entwickeln mit einem Entwickler, um eine Struktur in dem Resist-Oberschichtfilm zu bilden;
(II-5) Übertragen der Struktur auf den siliziumhaltigen Resist-Mittelschichtfilm durch Trockenätzen unter Verwendung des Resist-Oberschichtfilms mit der gebildeten Struktur als Maske;
(II-6) Übertragen der Struktur auf den metallhaltigen Film durch Trockenätzen unter Verwendung des siliziumhaltigen Resist-Mittelschichtfilms mit der übertragenen Struktur als Maske; und
(II-7) Bearbeiten des zu bearbeitenden Substrats unter Verwendung des metallhaltigen Films mit der gebildeten Struktur als Maske, um die Struktur in dem zu bearbeitenden Substrat zu bilden.

10. Verfahren zum Strukturieren eines zu bearbeitenden Substrats, umfassend die folgenden Schritte:
(III-1) Aufbringen der Zusammensetzung zur Bildung eines metallhaltigen Films gemäß einem der Ansprüche 5 bis 7 auf ein zu bearbeitendes Substrat, gefolgt von Erhitzen, um einen metallhaltigen Film zu bilden;
(III-2) Ausbilden eines anorganischen Hartmasken-Mittelschichtfilms, ausgewählt aus einem Siliziumoxidfilm, einem Siliziumnitridfilm und einem Siliziumoxynitridfilm, auf dem metallhaltigen Film;
(III-3) Ausbilden eines organischen Dünnfilms auf dem anorganischen Hartmasken-Mittelschichtfilm;
(III-4) Ausbilden eines Resist-Oberschichtfilms auf dem organischen Dünnfilm unter Verwendung eines Fotoresistmaterials;
(III-5) Unterziehen des Resist-Oberschichtfilms einer Strukturbelichtung und anschließendes Entwickeln mit einem Entwickler, um eine Struktur in dem Resist-Oberschichtfilm zu bilden;
(III-6) Übertragen der Struktur auf den organischen Dünnfilm und den anorganischen Hartmasken-Mittelschichtfilm durch Trockenätzen unter Verwendung des Resist-Oberschichtfilms mit der gebildeten Struktur als Maske;
(III-7) Übertragen der Struktur auf den metallhaltigen Film durch Trockenätzen unter Verwendung des anorganischen Hartmasken-Mittelschichtfilms mit der übertragenen Struktur als Maske; und
(III-8) Bearbeiten des zu bearbeitenden Substrats unter Verwendung des metallhaltigen Films mit der gebildeten Struktur als Maske, um die Struktur in dem zu bearbeitenden Substrat zu bilden.

11. Verfahren zum Strukturieren gemäß Anspruch 10, wobei der anorganische Hartmasken-Mittelschichtfilm durch ein CVD-Verfahren oder ein ALD-Verfahren gebildet wird.

12. Verfahren zum Strukturieren eines zu bearbeitenden Substrats, umfassend die folgenden Schritte:
(IV-1) Ausbilden eines Resist-Untergrundfilms auf einem zu bearbeitenden Substrat;
(IV-2) Aufbringen der Zusammensetzung zur Bildung eines metallhaltigen Films gemäß einem der Ansprüche 5 bis 7 auf den Resist-Untergrundfilm, gefolgt von Erhitzen, um einen metallhaltigen Film zu bilden;
(IV-3) Ausbilden eines Resist-Oberschichtfilms auf dem metallhaltigen Film durch Fotolithografie unter Verwendung eines Fotoresistmaterials oder durch Ausbilden einer organischen Klebeschicht auf dem metallhaltigen Film durch Schleuderbeschichten und Ausbilden eines Resist-Oberschichtfilms auf der organischen Klebeschicht unter Verwendung eines Fotoresistmaterials durch Fotolithografie;
(IV-4) Unterziehen des Resist-Oberschichtfilms einer Strukturbelichtung und anschließendes Entwickeln mit einem Entwickler, um eine Struktur in dem Resist-Oberschichtfilm zu bilden;
(IV-5) Übertragen der Struktur auf den organischen Klebefilm und den metallhaltigen Film oder den metallhaltigen Film durch Trockenätzen unter Verwendung des Resist-Oberschichtfilms mit der gebildeten Struktur als Maske;
(IV-6) Übertragen der Struktur auf den Resist-Untergrundfilm durch Trockenätzen unter Verwendung des metallhaltigen Films mit der übertragenen Struktur als Maske; und
(IV-7) Bearbeiten des zu bearbeitenden Substrats unter Verwendung des Resist-Untergrundfilms mit der gebildeten Struktur als Maske, um die Struktur in dem zu bearbeitenden Substrat zu bilden.

13. Verfahren zum Tonumkehr-Strukturieren eines zu bearbeitenden Substrats, umfassend die folgenden Schritte:
(V-1) Ausbilden eines Resist-Untergrundfilms auf einem zu bearbeitenden Substrat;
(V-2) Ausbilden eines Resist-Mittelschichtfilms oder einer Kombination aus einem anorganischen Hartmasken-Mittelschichtfilm, ausgewählt aus einer Siliziumoxidschicht, einer Siliziumnitridschicht und einer Siliziumoxynitridschicht, und einer organischen Dünnschicht auf dem Resist-Untergrundfilm;
(V-3) Ausbilden eines Resist-Oberschichtfilms auf dem Resist-Mittelschichtfilm oder der Kombination aus einem anorganischen Hartmasken-Mittelschichtfilm und einer organischen Dünnschicht unter Verwendung eines Fotoresistmaterials;
(V-4) Unterziehen des Resist-Oberschichtfilms einer Strukturbelichtung und anschließendes Entwickeln mit einem Entwickler, um eine Struktur in dem Resist-Oberschichtfilm zu bilden;
(V-5) Übertragen der Struktur auf den Resist-Mittelschichtfilm oder die organische Dünnschicht und den anorganische Hartmasken-Mittelschichtfilm durch Trockenätzen unter Verwendung des Resist-Oberschichtfilms mit der gebildeten Struktur als Maske;
(V-6) Übertragen der Struktur auf den Resist-Oberschichtfilm durch Trockenätzen unter Verwendung des Resist-Mittelschichtfilms oder des anorganischen Hartmasken-Mittelschichtfilms mit der übertragenen Struktur als Maske;
(V-7) Aufbringen der Zusammensetzung zur Bildung eines metallhaltigen Films gemäß einem der Ansprüche 5 bis 7 auf den Resist-Untergrundfilm mit der gebildeten Struktur, gefolgt von Erhitzen, um den Resist-Untergrundfilm mit einem metallhaltigen Film zu bedecken, wodurch ein Raum zwischen den Strukturen des Resist-Untergrundfilms mit dem metallhaltigen Film gefüllt wird;
(V-8) Zurückätzen des metallhaltigen Films, der den Resist-Untergrundfilm mit der gebildeten Struktur bedeckt, durch einen chemischen Stripper oder Trockenätzen, um eine Oberseite des Resist-Untergrundfilms mit der gebildeten Struktur freizulegen;
(V-9) Entfernen des Resist-Mittelschichtfilms oder des anorganischen Hartmasken-Mittelschichtfilms, der auf der Oberseite des Resist-Untergrundfilms verbleibt, durch Trockenätzen;
(V-10) Entfernen des Resist-Untergrundfilms mit der gebildeten Struktur, deren Oberfläche freigelegt ist, durch Trockenätzen, um eine umgekehrte Struktur einer ursprünglichen Struktur auf dem metallhaltigen Film zu bilden; und
(V-11) Bearbeiten des zu bearbeitenden Substrats unter Verwendung des metallhaltigen Films mit der gebildeten umgekehrten Struktur als Maske, um die umgekehrte Struktur in dem zu bearbeitenden Substrat zu bilden.

## Revendications

1. Composé pour former un film contenant du métal à incorporer à une composition destinée à former un film contenant du métal, le composé étant représenté par la formule générale suivante (M),
Tₙ-Sn-Qₘ **(M)**
dans laquelle T représente un groupe représenté par la formule générale (1) suivante ou un groupe représenté par la formule générale (1') suivante, au moins un T représentant un groupe représenté par la formule générale (1) suivante et T étant éventuellement un seul type ou une combinaison d'au moins deux types; Q représente un groupe alkyle substitué ou non substitué ayant 1 à 20 atomes de carbone, un groupe cycloalkyle substitué ou non substitué ayant 3 à 20 atomes de carbone, un groupe organique aliphatique insaturé substitué ou non substitué ayant 2 à 20 atomes de carbone et comportant une ou plusieurs doubles liaisons ou triples liaisons, un groupe aryle substitué ou non substitué ayant 6 à 30 atomes de carbone, un groupe arylalkyle substitué ou non substitué ayant 7 à 31 atomes de carbone, ou une combinaison de ces groupes; et « m » et « n » représentent tout nombre entier, à condition que « m » et « n » satisfassent la relation m+n = 4, m ≥ 1 et n ≥ 2, 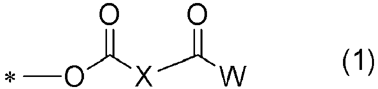 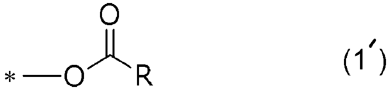
dans laquelle X représente un groupe organique divalent ayant 1 à 31 atomes de carbone, W représente un groupe représenté par l'une des formules générales (W-1) à (W-4) suivantes, et « * » représente un point de fixation à un atome Sn dans la formule générale (1); et R représente n'importe quel substituant et « * » représente un point de fixation à un atome Sn dans la formule générale (1'), 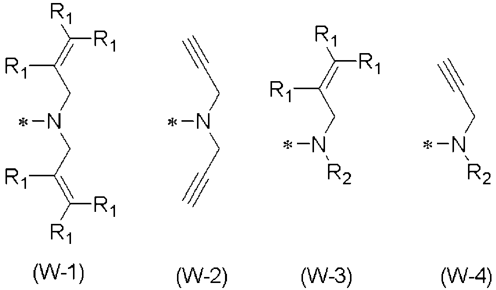
dans laquelle les R₁' représentent chacun un atome d'hydrogène ou un groupe méthyle et sont identiques ou différents les uns des autres dans les formules générales (W-1) et (W-3); et R₂ représente un atome d'hydrogène, un groupe organique monovalent saturé substitué ou non substitué ayant 1 à 20 atomes de carbone ou un groupe organique monovalent insaturé substitué ou non substitué ayant 2 à 20 atomes de carbone, un groupe aryle substitué ou non substitué ayant 6 à 30 atomes de carbone, ou un groupe arylalkyle substitué ou non substitué ayant 7 à 31 atomes de carbone dans (W-3) et (W-4), et « * » représente un point de fixation à un groupe carbonyle.

2. Composé pour former un film contenant du métal selon la revendication 1, dans lequel le X dans la formule générale (1) représente un groupe hydrocarbone insaturé ayant 2 à 20 atomes de carbone.

3. Composé pour former un film contenant du métal selon la revendication 2, dans lequel le X dans la formule générale (1) représente un groupe représenté par l'une des formules générales (2) suivantes, 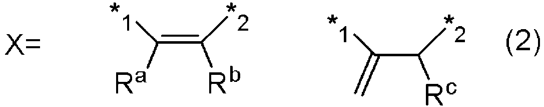 dans laquelle R^{a} et R^{b} représentent chacun un atome d'hydrogène ou un groupe organique monovalent ayant 1 à 18 atomes de carbone; R^{c} représente un atome d'hydrogène ou un groupe organique monovalent ayant 1 à 17 atomes de carbone; R^{a} et R^{b} dispose 0 à 18 atomes de carbone au total, R^{a} et R^{b} étant éventuellement liés l'un à l'autre pour former un substituant cyclique; et « *1 » et « *2 » représentent chacun un point de fixation à un groupe carbonyle, « *1 » et « *2 » pouvant éventuellement être inversés.

4. Composé pour former un film de sous-couche de résine photosensible selon l'une quelconque des revendications 1 à 3, dans lequel la composé pour former un film contenant du métal satisfait la relation 1,00 ≤ Mw/Mn ≤ 1,50, dans laquelle Mw est une masse moléculaire moyenne en poids et Mn une masse moléculaire moyenne en nombre mesurée par chromatographie par perméation de gel en termes de polystyrène.

5. Composition pour former un film contenant du métal utilisé dans la fabrication de semiconducteur, la composition comprenant: (A) le composé pour former un film contenant du métal selon l'une quelconque des revendications 1 à 4; et (B) un solvant organique.

6. Composition pour former un film contenant du métal selon la revendication 5, comprenant en outre un ou plusieurs parmi (C) un agent de réticulation, € un tensioactif, (F) un accélérateur de fluidité, et (G) un générateur d'acide.

7. Composition pour former un film contenant du métal selon la revendication 5 ou 6, dans laquelle le solvant organique (B) contient, en tant que (B1) solvant à point d'ébullition élevé, un ou plusieurs types de solvant organique ayant un point d'ébullition supérieur ou égal à180 °C.

8. Procédé de formation de motif permettant de former un motif dans un substrat à traiter, comprenant les étapes consistant à:
(I-1) appliquer la composition servant à former un film contenant du métal selon l'une quelconque des revendications 5 à 7 sur un substrat à traiter, puis chauffer pour former un film contenant du métal;
(I-2) former un film de couche supérieure de résine photosensible sur le film contenant du métal en faisant appel à un matériau de résine photosensible;
(I-3) soumettre le film de couche supérieure de résine photosensible à une exposition de motif, puis à un développement en faisant appel à un révélateur pour former un motif dans le film de couche supérieure de résine photosensible;
(I-4) transférer le motif sur le film contenant du métal par gravure à sec tout en utilisant le film de couche supérieure de résine photosensible ayant le motif formé comme masque; et
(I-5) traiter le substrat à traiter tout en utilisant le film contenant du métal ayant le motif formé comme masque pour former le motif dans le substrat à traiter.

9. Procédé de formation de motif permettant de former un motif dans un substrat à traiter, comprenant les étapes consistant à:
(II-1) appliquer la composition servant à former un film contenant du métal selon l'une quelconque des revendications 5 à 7 sur un substrat à traiter, puis chauffer pour former un film contenant du métal;
(II-2) former un film de couche intermédiaire de résine photosensible contenant du silicium sur le film contenant du métal;
(II-3) former un film de couche supérieure de résine photosensible sur le film de couche intermédiaire de résine photosensible contenant du silicium à l'aide d'un matériau de résine photosensible;
(II-4) soumettre le film de couche supérieure de résine photosensible à une exposition de motif, puis à un développement à l'aide d'un révélateur pour former un motif dans le film de couche supérieure de résine photosensible;
(II-5) transférer le motif sur le film de couche intermédiaire de résine photosensible contenant di silicium par gravure à sec tout en utilisant le film de couche supérieure de résine photosensible ayant le motif formé comme masque;
(II-6) transférer le motif sur le film contenant du métal par gravure à sec tout en utilisant le film de couche intermédiaire de résine photosensible contenant du silicium comportant le motif transféré comme masque; et
(II-7) traiter le substrat à traiter tout en utilisant le film contenant du métal comportant le motif formé comme masque afin de former le motif dans le substrat à traiter.

10. Procédé de formation de motif permettant de former un motif dans un substrat à traiter, comprenant les étapes consistant à:
(III-1) appliquer la composition servant à former un film contenant du métal selon l'une quelconque des revendications 5 à 7 sur un substrat à traiter, puis chauffer pour former un film contenant du métal;
(III-2) former un film de couche intermédiaire de masque dur inorganique choisi parmi un film d'oxyde de silicium, un film de nitrure de silicium et un film d'oxynitrure de silicium sur le film contenant du métal;
(III-3) former un film mince organique sur le film de couche intermédiaire de masque dur inorganique;
(III-4) former un film de couche supérieure de résine photosensible sur le film mince organique à l'aide d'un matériau de résine photosensible;
(III-5) soumettre le film de couche supérieure de résine photosensible à une exposition de motif, puis à un développement à l'aide d'un révélateur pour former un motif dans le film de couche supérieure de résine photosensible;
(III-6) transférer le motif sur le film mince organique et le film de couche intermédiaire de masque dur inorganique par gravure à sec tout en utilisant le film de couche supérieure de résine photosensible ayant le motif formé comme masque;
(III-7) transférer le motif sur le film contenant du métal par gravure à sec tout en utilisant le film de couche intermédiaire de masque dur inorganique comportant le motif transféré comme masque; et
(III-8) traiter le substrat à traiter tout en utilisant le film contenant du métal comportant le motif formé comme masque afin de former le motif dans le substrat à traiter.

11. Procédé de formation de motif selon la revendication 10, dans lequel le film de couche intermédiaire de masque dur inorganique est formé selon une méthode CVD ou une méthode ALD.

12. Procédé de formation de motif permettant de former un motif dans un substrat à traiter, comprenant les étapes consistant à:
(IV-1) former un film de sous-couche de résine photosensible sur u substrat à traiter;
(IV-2) appliquer la composition pour former un film contenant du métal selon l'une quelconque des revendications 5 à 7 sur le film de sous-couche de résine photosensible, puis chauffer pour former un film contenant du métal;
(IV-3) former un film de couche supérieure de résine photosensible sur le film contenant du métal à l'aide d'un matériau de résine photosensible ou former un film adhésif organique sur le film contenant du métal par revêtement par rotation et former un film de couche supérieure de résine photosensible sur le film adhésif organique à l'aide d'un matériau de résine photosensible;
(IV-4) soumettre le film de couche supérieure de résine photosensible à une exposition de motif, puis à un développement à l'aide d'un révélateur pour former un motif dans le film de couche supérieure de résine photosensible;
(IV-5) transférer le motif sur le film adhésif organique et le film contenant du métal ou sur le film contenant le métal par gravure à sec tout en utilisant le film de couche supérieure de résine photosensible ayant le motif formé comme masque;
(IV-6) transférer le motif sur le film de sous-couche de résine photosensible par gravure à sec tout en utilisant le film de couche intermédiaire de résine photosensible comportant le motif transféré comme masque; et
(IV-7) traiter le substrat à traiter tout en utilisant le film de sous-couche de résine photosensible comportant le motif formé comme masque afin de former le motif dans le substrat à traiter.

13. Procédé de formation de motif à inversion de ton permettant de former un motif dans un substrat à traiter, comprenant les étapes consistant à:
(V-1) former un film de sous-couche de résine photosensible sur un substrat à traiter;
(V-2) former un film de couche intermédiaire de résine photosensible ou une combinaison d'un film de couche intermédiaire de masque dur inorganique sélectionné parmi un film d'oxyde de silicium, un film de nitrure de silicium et un film d'oxynitrure de silicium et un film mince organique sur le film de sous-couche de résine photosensible;
(V-3) former un film de couche supérieure de résine photosensible sur le film de couche intermédiaire de résine photosensible ou sur la combinaison du film de couche intermédiaire de masque dur inorganique et du film mince organique à l'aide d'un matériau de résine photosensible;
(V-4) soumettre le film de couche supérieure de résine photosensible à une exposition de motif, puis à un développement à l'aide d'un révélateur afin de former un motif dans le film de couche supérieure de résine photosensible;
(V-5) transférer le motif sur le film de couche intermédiaire de résine photosensible ou le film mince organique et le film de couche intermédiaire de masque dur inorganique par gravure à sec tout en utilisant le film de couche supérieure de résine photosensible ayant le motif formé comme masque;
(V-6) transférer le motif sur le film de sous-couche de résine photosensible par gravure à sec tout en utilisant le film de couche intermédiaire de résine photosensible ou le film de couche intermédiaire de masque dur inorganique ayant le motif transféré comme masque;
(V-7) appliquer la composition pour former un film contenant du métal selon l'une quelconque des revendications 5 à 7 sur le film de sous-couche de résine photosensible ayant le motif formé, puis chauffer pour recouvrir le film de sous-couche de résine photosensible d'un film contenant du métal, remplissant ainsi un espace entre les motifs du film de sous-couche de résine photosensible avec le film contenant du métal;
(V-8) graver en retrait le film contenant du métal recouvrant le film de sous-couche de résine photosensible comportant le motif formé à l'aide d'un décapant chimique ou par gravure à sec afin de mettre à nu une surface supérieure du film de sous-couche de résine photosensible présentant le motif formé;
(V-9) retirer le film de couche intermédiaire de résine photosensible ou le film de couche intermédiaire de masque dur inorganique restant sur la surface supérieure du film de sous-couche de résine photosensible par gravure à sec;
(V-10) retirer le film de sous-couche de résine photosensible présentant le motif formé dont la surface est mise à nu par gravure à sec afin de former un motif inversé d'un motif d'origine sur le film contenant du métal; et
(V-11) traiter le substrat à traiter tout en utilisant le film contenant du métal présentant le motif inversé formé comme masque afin de former le motif inversé dans le substrat à traiter.
